(19) Europäisches Patentamt
European Patent Office
Office européen des brevets

(11) Veröffentlichungsnummer: **0 203 030 B1**

(12) # EUROPÄISCHE PATENTSCHRIFT

(45) Veröffentlichungstag der Patentschrift: **20.03.91**

(51) Int. Cl.[5]: **C08G 77/10**, C08G 69/26

(21) Anmeldenummer: **86810161.9**

(22) Anmeldetag: **07.04.86**

Die Akte enthält technische Angaben, die nach dem Eingang der Anmeldung eingereicht wurden und die nicht in dieser Patentschrift enthalten sind.

(54) **Beschichtetes Material und seine Verwendung.**

(30) Priorität: **11.04.85 CH 1553/85**

(43) Veröffentlichungstag der Anmeldung:
**26.11.86 Patentblatt 86/48**

(45) Bekanntmachung des Hinweises auf die Patenterteilung:
**20.03.91 Patentblatt 91/12**

(84) Benannte Vertragsstaaten:
**BE CH DE FR GB IT LI NL SE**

(56) Entgegenhaltungen:
**EP-A- 0 071 749**
**EP-A- 0 134 752**
**GB-A- 1 140 610**
**EP-A- 0 132 221**
**DE-A- 3 018 069**
**US-A- 3 855 273**

**JOURNAL OF POLYMER SCIENCE: MACROMOLECULAR REVIEWS, Band 11, 1976, Seiten 161-208; C.E. SROOG: "Polyimides"**

(73) Patentinhaber: **CIBA-GEIGY AG**
**Klybeckstrasse 141**
**CH-4002 Basel(CH)**

(72) Erfinder: **Pfeifer, Josef, Dr.**
**Brunnmattstrasse 32**
**CH-4106 Therwil(CH)**

**EP 0 203 030 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Vorliegende Erfindung betrifft ein beschichtetes Material, bei dem auf mindestens einer Oberfläche eines Trägermaterials eine Schicht eines Polyamidsäureesters auf der Basis von Benzophenongruppen enthaltenden aromatischen Tri- oder Tetracarbonsäuren aufgebracht ist, und die Verwendung des beschichteten Materials zur Herstellung von Schutzüberzügen und Reliefabbildungen.

In der EP-A-0 134 752 sind durch Strahlung vernetzbar beschichtete Materialen beschrieben, bei dem die strahlungsempfindliche Schicht aus einem Polyimid auf der Basis von Benzophenontetracarbonsäure bestehen kann. In der EP-A-0 138 768 sind strahlsungsempfindliche Polyimide beschrieben. In der US-PS 3,855,273 sind Polyamidsäureester mit Benzophenontetracarbonsäuren als Beschichtungsmittel für Drähte zur Erzeugung einer Isolierschicht aus Polyimiden beschrieben. Ferner ist aus der DE-A-3,018,069 bekannt, dass sich Polyamidsäuren oder deren Salze durch die Einwirkung von ultravioletter Strahlung härten lassen. Es ist wünschenswert, weitere strahlungsempfindliche Vorstufen von Polyimiden bereitzustellen, da diese im allgemeinen leichter löslich sind, was bei der Beschichtung von Trägermaterialien vorteilhaft ist.

Gegenstand vorliegender Erfindung ist ein Verfahren zur Herstellung von Vernetzten Polymeren, das dadurch gekennzeichnet, dass man Polyamidsäureester enthaltend (a) 50 bis 100 Mol-%, bezogen auf den Polyamidsäureester, mindestens eines wiederkehrenden Strukturelementes der Formel I oder II oder Mischungen hiervon,

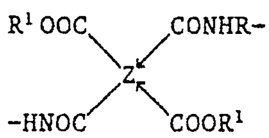 (I) 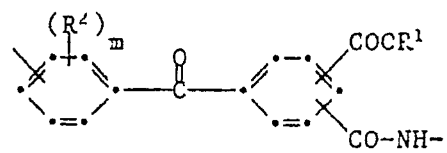 (II)

und

b) 0 bis 50 Mol-% mindestens eines wiederkehrenden Strukturelementes der Formeln III oder IV oder Mischungen hiervon mit energiereicher Strahlung bestrahlt,

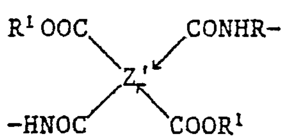 (III) 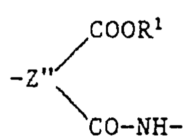 (IV),

worin die Pfeile für Stellungsisomerie stehen, Z einen vierwertigen phenylaromatischen Rest bedeutet, der eine Benzophenonstruktureinheit enthält, bei dem je eine der Estergruppen und Amidgruppen in Formel I in Orthostellung entweder an einen Phenylrest oder an zwei verschiedene Phenylreste gebunden sind, und die Ester- und Amidgruppe in Formel II in Orthostellung gebunden sind,

Z' für einen vierwertigen, von Z verschiedenen aromatischen Rest und

Z" für einen dreiwertigen von Rest der Formel II verschiedenen aromatischen Rest stehen, in denen je eine Ester- und Amidgruppe in Orthostellung oder Peristellung gebunden sind,

R einen unsubstituierten oder substituierten zweiwertigen organischen Rest bedeutet,

$R^1$ einen gesättigten aliphatischen Kohlenwasserstoffrest darstellt,

und

$R^2$ für einen Substituenten steht, und m 0 oder eine Zahl von 1-4 bedeutet, enthält.

Ein weiterer Gegenstand der Erfindung ist ein beschichtetes Material, bei dem auf mindestens einer Oberfläche eines Trägermaterials eine Schicht mindestens eines Polyamidsäureesters aufgebracht ist, dadurch gekennzeichnet, dass der Polyamidsäureester die oben definierten Strukturelemente I und/oder II und gegebenenfalls III und/oder IV in den oben definierten Mengen enthält, worin z, z', z" und $R^1$ die oben definierte Bedeutung besitzen und R ein substituierter oder unsubstituierter zweiwertiger aliphatischer, cycloaliphatischer oder araliphatischer Rest oder ein mit Alkyl, Alkoxyalkyl, Alkoxy, Trimethylen oder Tetramethylen substituierter zweiwertiger aromatischer Rest ist.

Die Komponente (a) ist vorzugsweise zu 80 bis 100, insbesondere zu 90-100 Mol-% und die Komponente (b) ist vorzugsweise zu 0 bis 20, insbesondere zu 0 bis 10 Mol-% enthalten. Die Komponenten (a) und/oder (b) können ferner durch bis zu 50 Mol-%, vorzugsweise bis zu 30 Mol-% und insbesondere bis zu 15 Mol-% der entsprechenden Polyamidsäuren ersetzt sein, bezogen auf die Komponenten (a) bzw. (b) (in den Formeln I bis IV ist für diesen Fall der entsprechende Teil $R^1$ ein Wasserstoffatom).

Z in Formel I entspricht bevorzugt den Formeln

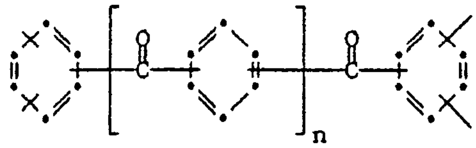
(V),

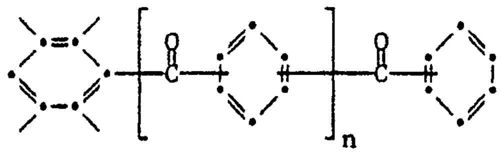
(VI),

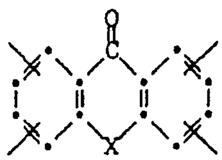
(VII)

worin n für 0 oder 1 und X für eine direkte Bindung $-CH_2-$, -O-, -S-, -SO-, $-SO_2-$, $-NR^x-$, $-CR^xR^y-$ oder -CO- stehen, und die freien Bindungen in Orthostellung gebunden sind, $R^x$ für H oder $C_1$-$C_6$-Alkyl, Phenyl, Benzyl oder Cyclohexyl steht und $R^y$ die Bedeutung von $R^x$ hat, aber nicht H ist.

Die Reste der Formeln V, VI und VII können substituiert sein, z.B. mit $C_1$-$C_4$-Alkyl oder -Alkoxy oder durch Halogen wie z.B. Cl.

X in Formel VII ist bevorzugt -O- oder -CO-. In einer bevorzugten Ausführungsform entspricht Z den Formeln

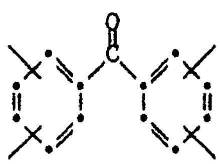
oder
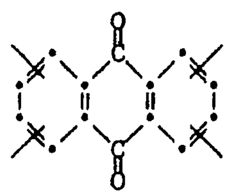
oder
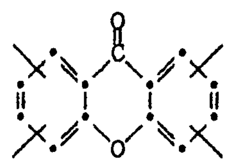

$R^2$ in Formel II kann als Substituent z.B. $C_1$-$C_4$-Alkyl sein und m ist bevorzugt 1, 2, 3 oder 4. Bevorzugt ist $R^2$ ein Wasserstoffatom oder Methyl.

Z' enthält als vierwertiger aromatischer Rest bevorzugt 6 bis 30 C-Atome, besonders 6 bis 20 C-Atome. In einer bevorzugten Untergruppen entspricht Z' den Formeln

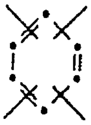 , 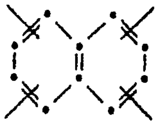 , 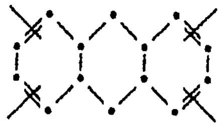 , 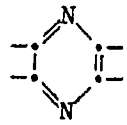 , 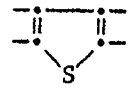 ,

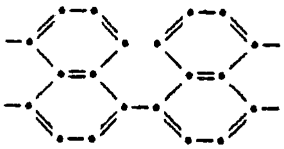 , 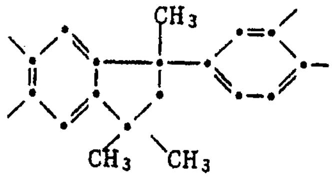 , 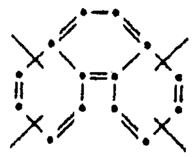 ,

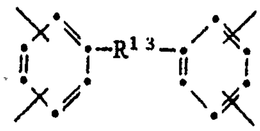

worin $R^{13}$ eine direkte Bindung oder eine Brückengruppe der Formeln

$-O-$, $-S-$, $-SO_2-$, 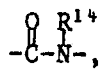 , 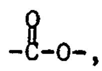 , 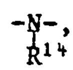 , 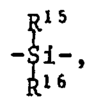 , 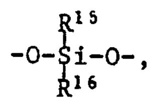 , 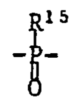 ,

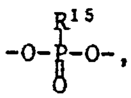 , $-N=N-$, 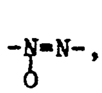 , $-NH-$, 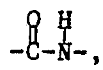 , $-CH_2-$, $-CH_2CH_2-$, 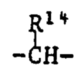 ,

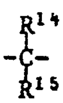 , 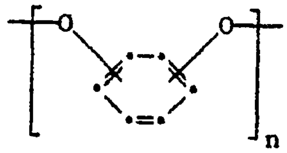 , 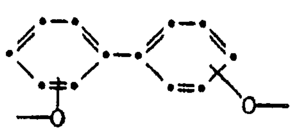

ist, worin $R^{14}$, $R^{15}$ und $R^{16}$ Alkyl mit 1 bis 6-C-Atomen, Phenyl oder Benzyl und $R^{15}$ und $R^{16}$ auch Alkoxy mit 1 bis 6-C-Atomen, Phenyloxy oder Benzyloxy sind.

In den voranstehenden Formeln befinden sich stets je zwei der freien Bindungen in Peri- und/oder Orthostellung.

Eine bevorzugte Untergruppe für Z' sind Reste der Formeln

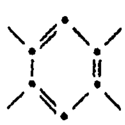 oder 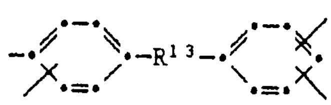 ,

worin $R^{13}$ eine direkte Bindung, -O-, $-SO_2-$ oder $CH_2$ ist. Die freien Bindungen befinden sich in Orthostellung.

Ganz besonders bevorzugt ist Z' ein Rest der Formel

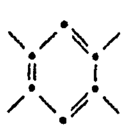

Beispiele für Tetracarbonsäureanhydride mit einem Rest Z' sind:
2,3,9,10-Perylentetracarbonsäuredianhydrid,
1,4,5,8-Naphthalintetracarbonsäuredianhydrid,
2,6-Dichlornapthalin-1,4,5,8-tetracarbonsäuredianhydrid,
2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
Pyromellitsäuredianydrid,
3,3',4,4'-Biphenyltetracarbonsäuredianhydrid,
2,2',3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
4,4'-Sulfonyldiphthalsäureanhydrid,
3,3'-Oxydiphthalsäureanhydrid,
4,4'-Methylendiphthalsäureanhydrid,
4,4'-Thiodiphthalsäureanhydrid,
4,4'-Ethylidendiphthalsäureanhydrid,
2,3,6,7-Naphthalintetracarbonsäuredianhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Thiophen-2,3,4,5-tetracarbonsäuredianhydrid,
1-(3',4'-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)-3-methylindan-5,6-dicarbonsäuredianhydrid,
1-(3',4'-Dicarboxyphenyl)-3-methylindan-6,7-dicarbonsäuredianhydrid.

Z" in Formel IV entspricht bevorzugt Resten der Formeln

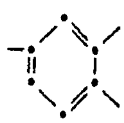 , 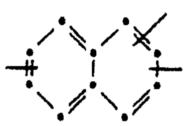 oder 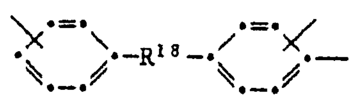 ,

worin $R^{18}$ eine Brückengruppe oder eine direkte Bindung darstellt und die freien Bindungen in Orthostellung gebunden sind. $R^{18}$ ist als Brückengruppe bevorzugt -O-, -S-, -SO-, $-SO_2-$, $-CH_2-$ oder Alkyliden mit 2 bis 6 C-Atomen, Cyclopentyliden oder Cyclohexyliden.

$R^1$ als gesättigter aliphatischer Rest ist bevorzugt unsubstituiertes oder substituiertes, lineares oder verzweigtes Alkyl; Cycloalkyl und Aralkyl (arylsubstituiertes Alkyl). Das Alkyl kann durch Heteroatome wie z.B. -O- oder -S- unterbrochen sein. Das Alkyl enthält bevorzugt 1 bis 18, besonders 1 bis 12 und insbesondere 1 bis 6 C-Atome. Das Cycloalkyl enthält bevorzugt 5 oder 6 Ring-C-Atome und es kann substituiert sein, z.B. mit $C_1$-$C_4$-Alkyl. Das Aralkyl enthält bevorzugt 1 oder 2 C-Atome in der Alkylgruppe und ist bevorzugt Phenylethyl oder Benzyl. Das Aralkyl kann substituiert sein, z.B. mit $C_1$-$C_4$-Alkyl. Geeignete Substituenten für $R^1$ als Alkyl sind z.B. Hydroxyl, Cyano, Cyclopentyl, und Cyclohexyl.

Beispiele für $R^1$ sind: Methyl, Ethyl, n-Propyl, i-Propyl, n-Butyl, i-Butyl, Pentyl, Hexyl, 2-Ethylhexyl, Heptyl, Octyl, Nonyl, Decyl, Undecyl, Dodecyl, Tetradecyl, Hexadecyl, Octadecyl, $\beta$-Methoxethyl, $\beta$-Ethoxyethyl, $\beta$-Hydroxyethyl, $\gamma$-Hydroxypropyl, Cyclohexylmethyl, Cyclohexyl, Cyclopentyl, Methylcyclohexyl, Benzyl, $\beta$-Phenylethyl, Methylbenzyl.

In einer bevorzugten Ausführungsform steht $R^1$ für $C_1$-$C_4$-Alkyl und Benzyl.

R als zweiwertiger organischer Rest ist bevorzugt ein unsubstituierter oder substituierter zweiwertiger aliphatischer, cycloaliphatischer, araliphatischer oder aromatischer Rest.

R in den Formeln I bis IV in der Bedeutung als zweiwertiger aliphatischer Rest enthält bevorzugt 2 bis 30 C-Atome. Besonders enthält der Rest 6 bis 30 und insbesondete 6 bis 20 C-Atome. In einer bevorzugten Untergruppe ist R lineares oder verzweigtes Alkylen, das durch Sauerstoffatome, $NR^a$, $^+NR^a{}_2G^-$, Cyclopentylen, Cyclohexylen, Naphthylen, Phenylen oder Hydantoinreste unterbrochen sein kann. $R^a$ kann z.B. Alkyl mit 1 bis 12 C-Atomen oder Cycloalkyl mit 5 oder 6 Ring-C-Atomen, Phenyl oder Benzyl sein. $G^-$ bedeutet ein Anion einer Protonensäure, z.B. Halogenid, Sulfat, Phospat. In einer weiteren bevorzugten Ausführungform ist R lineares oder verzweigtes Alkylen, $-(CH_2)_x-R^3-(CH_2)_y-$, worin $R^3$ Phenylen, Naphthylen, Cyclopentylen oder Cyclohexylen und x und y unabhängig voneinander die Zahl 1, 2 oder 3 sind, $-R^4-(OR^5)_p-O-R^4-$, worin $R^4$ Ethylen, 1,2-Propylen, 1,3-Propylen oder 2-Methyl-1,3-Propylen und $R^5$ Ethylen, 1,2-Propylen, 1,2-Butylen, 1,3-Propylen, 1,3-Butylen oder 1,4-Butylen und p eine Zahl von 1 bis 100 sind, oder

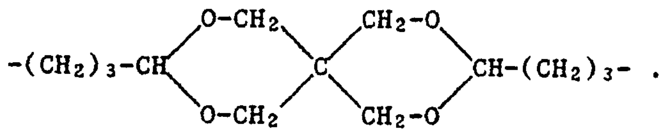

Beispiele für aliphatische Reste sind: Ethylen, 1,2- oder 1,3-Propylen, 2,2-Dimethyl-1,3-propylen, 1,2-, 1,3- oder 1,4-Butylen, 1,3 -oder 1,5-Pentylen, Hexylene, Heptylene, Octylene, Decylene, Dodecylene, Tetradecylene, Hexadecyclene, Octadecylene, Eicosylene, 2,4,4-Trimethylhexylen, 1,10-Dialkyldecylen, wobei das Alkyl bevorzugt 1 bis 6 C-Atome aufweist, substituierte 1,11-Undecylene, wie sie z.B. in der EP-B-0 011 559 beschrieben sind, zweiwertige Reste von Jeffaminen wie z.B.

$-(CH_2)_3-(OCHCH_2)_p-O-(CH_2)_3$ mit p = 1 bis 100 oder

$-(CH_2)_3-(O(CH_2)_4)_p-O-(CH_2)_3$ mit p = 1-100, Dimethylencyclohexan

Xylylen und Diäthylenbenzol. Besonders bevorzugt ist R längerkettiges, verzweigtes Alkylen mit z.B. 6 bis 30 C-Atomen.

Bei den durch heterocyclische Reste unterbrochenen aliphatischen Resten kann es sich z.B. um solche handeln, die sich von N,N'-aminoalkylierten Hydantoinen oder Benzimidazolen ableiten. Beispiele sind N,N'-($\gamma$-Aminopropyl)5,5-dimethyl-hydantoin oder -benzimidazolen und solche der Formel

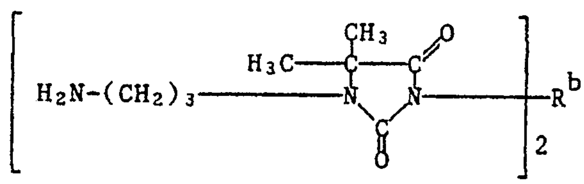

worin $R^b$ Alkylen mit 1 bis 12, bevorzugt 1 bis 4 C-Atomen oder

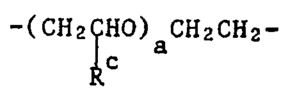

ist, worin $R^c$ ein Wasserstoffatom oder Methyl und a ganze Zahlen von 1-20 bedeuten.

Geeignete Substituenten für die aliphatischen Reste sind z.B. Halogene wie F oder Cl und Alkyl oder Alkoxy mit 1 bis 6 C-Atomen.

R in den Formeln I vis IV in seiner Bedeutung als zweiwertiger cycloaliphatischer Rest enthält bevorzugt 5 bis 8 Ring-C-Atome und ist besonders unsubstituiertes oder mit Alkyl, das vorzugsweise 1 bis 4 C-Atome enthält, substituiertes ein- oder zweikerniges Cycloalkylen mit 5 bis 7 Ring-C-Atomen. In einer bevorzugten Ausführungsform ist R als cycloaliphatischer Rest ein solcher der Formeln

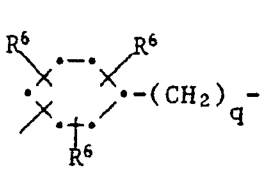

oder

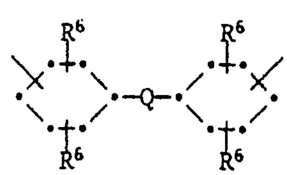

worin q 0 oder 1 ist, die $R^6$ unabhängig Wasserstoff oder Alkyl mit 1 bis 6 C-Atomen bedeuten und Q für eine direkte Bindung, O, S, $SO_2$, Alkylen mit 1 bis 3 C-Atomen oder Alkyliden mit 2 bis 6 C-Atomen steht. $R^6$ ist bevorzugt Ethyl und Methyl, Q bevorzugt Methylen und das Alkyliden enthält bevorzugt 2 oder 3 C-Atome, wie Ethyliden und 1,1- oder 2,2-Propyliden.

Beispiele für R als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 3- oder 4-Methylcyclohex-1-yl, 5-Methyl-3-methylencyclohex-1-yl, 3,3'- oder 4,4'-Bis-cyclohexylen, 3,3'-Dimethyl-4,4'-biscyclohexylen, 4,4'-Biscyclohexylenether oder -sulfon oder -methan oder -2,2-propan, sowie die zweiwertigen Reste von Bis-aminomethyltricyclodecan, Bis-aminomethylnorbornan und menthandiamin. Besonders bevorzugt als zweiwertiger cycloaliphatischer Rest ist 1,4- oder 1,3-Cyclohexylen, Methylenbis(cyclohex-4-yl) oder Methylenbis-(3-methylcyclohex-4-yl).

R als araliphatischer Reste enthält bevorzugt 7 bis 30 C-Atome. Sofern die aromatische Gruppe des araliphatischen Restes an N-Atome im Rest der Formel I oder II gebunden ist, was bevorzugt ist, so sind diese aromatischen Gruppen bevorzugt so substituiert wie R als aromatischer Rest, einschliesslich der Bevorzugungen. Der araliphatische Rest enthält bevorzugt 7 bis 26, besonders 8 bis 22 C-Atome. Der aromatische Rest im araliphatischen Rest ist bevorzugt ein Phenylrest. In seiner Bedeutung als araliphatischer Rest ist R besonders unsubstituiertes oder am Aryl durch Alkyl substituiertes Aralkylen, wobei derAlkylenrest linear oder verzweigt ist. In einer bevorzugten Ausführungsform entspricht der araliphatische Rest der Formel

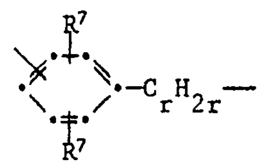

worin die $R^7$ unabhängig voneinander ein Wasserstoffatom oder besonders Alkyl mit 1-6 C-Atomen und r ganze Zahlen von 1-20 bedeuten. Die freie Bindung kann sich in o-Stellung, m-Stellung und besonders in p-Stellung zur $C_rH_{2r}$-Gruppe befinden und einer oder beide $R^7$ sind bevorzugt in o-Stellung zur freien Bindung gebunden.

Beispiele für R als zweiwertiger araliphatischer Rest sind; m- oder p-Benzylen, 3-Methyl-p-benzylen, 3-Ethyl-p-benzylen, 3,5-Dimethyl-p-benzylen, 3,5-Diethyl-p-benzylen, 3-Methyl-5-ethyl-p-benzylen, p-Phenylenpropylen, 3-Methyl-p-phenylen-propylen, p-Phenylenbutylen, 3-Ethyl-p-phenylenpentylen sowie insbesondere längerkettige Phenylenalkylenreste von Diaminen, die z.B. in der EP-A-0 069 062 beschrieben sind: 6-(p-Phenylen)-6-methylhept-2-yl, 6-(3'-Methyl-p-phenylen)-6-methylhept-2-yl, 6-(3'-Ethyl-p-phenylen)-6-methylhept-2-yl, 6-(3',5'-Dimethyl-p-phenylen)-6-methylhept-2-yl, 11-(p-Phenylen)-2,11-dimethyl-dodec-1-yl, 13-(p-Phenylen)-2,12-dimethyltetradec-3-yl.

Unter den Homo- und Copolyamidsäureestern sind besonders solche mit Strukturelementen der Formel I bis IV bevorzugt, in denen R unsubstituierte und besonders substituierte aromatische Reste bedeutet. Der Substituent am aromatischen Rest enthält bevorzugt 1 bis 20, besonders 1-12 und insbesondere 1-6 C-Atome. Insbesondere ist der Substituent lineares oder verzweigtes Alkyl, Alkoxy oder Alkoxyalkyl mit 1 bis 6 C-Atomen, Benzyl, Trimethylen oder Tetramethylen. Als Alkoxyalkyl ist Alkoxymethyl bevorzugt und als Alkoxy Methoxy. Beispiele für den Substituenten sind: Methyl, Ethyl, Propyl, Isopropyl, n-Butyl, Isobutyl, Pentyl, Hexyl, Octyl, Dodecyl, Tetradecyl, Eicosyl, Methoxy, Ethoxy, Propoxy, Butoxy, Pentoxy, Hexoxy, Methoxymethyl, Methoxyethyl, Ethoxymethyl, Propoxymethyl, Butoxymethyl, Benzyl, Methylbenzyl und Phenylethyl. Bevorzugte Reste sind Methoxymethyl, Ethoxymethyl, Methyl, Ethyl, Propyl, i-Propyl, Trimethylen und Tetramethylen. Besonders bevorzugt ist Methyl und Ethyl. Bei dem aromatischen Rest kann es sich um einkernige oder mehrkernige, besonders zweikernige Reste handeln. Einkernige Reste können 1 bis 4, bevorzugt 2 bis 4 und besonders 4 Substituenten enthalten und zweikernige Reste können 1 bis 4, bevorzugt 2 Substituenten in jedem Kern enthalten. Es wurde gefunden, dass die Lichtempfindlichkeit von Homo- oder Copolyamidsäureestern besonders hoch ist, wenn ein und besonders zwei Substituenten in Orthostellung zur NH-Gruppe gebunden sind. Ferner weisen solche Polyamidsäureester besonders gute thermomechanische Eigenschaften auf. Die Substitution in einer oder beiden Orthostellungen ist daher in diesem Fall bevorzugt. Der aromatische Rest ist bevorzugt in Meta- oder Parastellung zur NH-Gruppe gebunden.

R kann als aromatischer Rest 6 bis 30, besonders 6 bis 20 C-Atome enthalten. Der aromatische Rest ist bevorzugt ein Kohlenwasserstoffrest, besonders ein ein- oder zweikernige Phenylenrest, ein Naphthylenrest

oder einPyridinrest, der durch Alkyl, Alkoxyalkyl, Alkoxy, Trimethylen oder Tetramethylen substituiert ist.

Eine bevorzugte Untergruppe sind solche aromatische Reste der Formeln

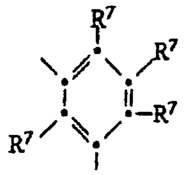 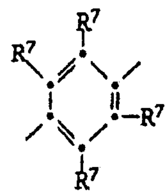 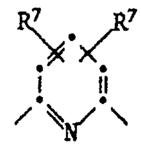 ,

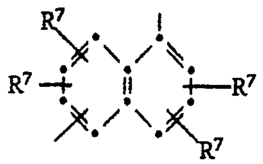 , 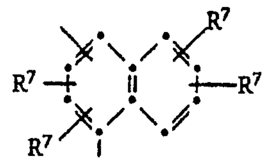 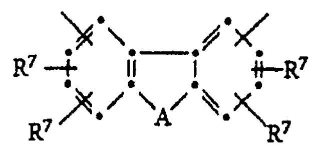

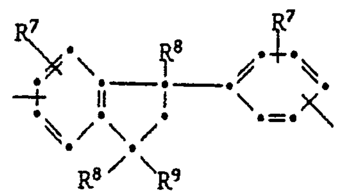 oder 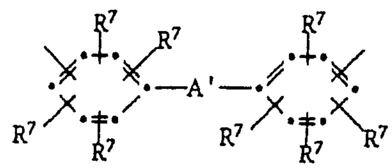

worin alle $R^7$ ein Wasserstoffatom, $R^7$ im Falle der Monosubstitution Alkyl mit 1 bis 6 C-Atomen und die anderen $R^7$ Wasserstoffatome sind, und im Falle der Di-, Tri- oder Tetrasubstitution zwei $R^7$ Alkyl mit 1 bis 6 C-Atomen und die anderen $R^7$ ein Wasserstoffatom oder Alkyl mit 1 bis 6 C-Atomen sind oder im Falle der Di-, Tri- oder Tetrasubstitution zwei vicinale $R^7$ im Phenylring für Trimethylen oder Tetramethylen und die anderen $R^7$ für ein Wasserstoffatom oder Alkyl mit 1 bis 6 C-Atomen stehen, A für O, S, NH, CO oder $CH_2$ steht, $R^8$ ein Wasserstoffatom oder Alkyl mit 1 bis 5 C-Atomen und $R^9$ Alkyl mit je 1 bis 5 C-Atomen darstellt, und A' eine direkte Bindung, O, S,

$SO_2$, CO, $\overset{\overset{O}{\|}}{C}O$, $\overset{\overset{O}{\|}}{C}NR^{10}$, $NR^{10}$, CONH, NH, $R^{10}SiR^{11}$, $R^{10}OSiOR^{11}$,

Alkylen mit 1 bis 6 C-Atomen oder Alkyliden mit 2 bis 6 C-Atomen, Phenylen oder Phenyldioxyl bedeutet, worin $R^{10}$ und $R^{11}$ unabhängig voneinander Alkyl mit 1 bis 6 C-Atomen oder Phenyl bedeuten. $R^8$ und $R^9$, sind bevorzugt Methyl, A steht bevorzugt für $-CH_2-$ oder -O- und A' bevorzugt für eine direkte Bindung, -O-, $-CH_2-$ oder Alkyliden mit 2 bis 4 C-Atomen. $R^{10}$ und $R^{11}$ stehen besonders für Methyl, Ethyl und Phenyl. Das Alkylen enthält bevorzugt 2 bis 4 C-Atome und ist besonders Ethylen.

Eine bevorzugte Untergruppe sind Toluylenreste, Reste o,o'-substituierter Diaminodiphenylene, Diaminodiphenylmethane und Diaminodiphenyläther.

Eine besonders bevorzugte Gruppe sind solche aromatischen Reste der Formeln

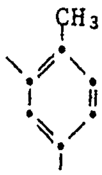 , 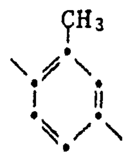 , 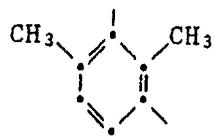 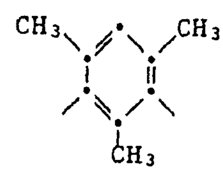

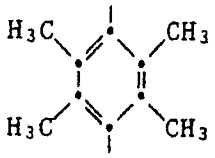 , 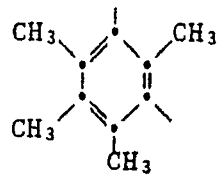 oder 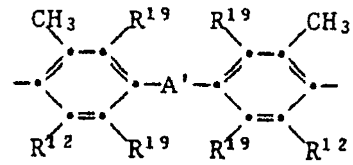

worin A' eine direkte Bindung, O und besonders $CH_2$ bedeutet und $R^{12}$ ein Wasserstoffatom und besonders Methyl oder Ethyl darstellt und $R^{19}$ ein Wasserstoffatom und besonders Methyl oder Ethyl ist.

Beispiele für unsubstituierte und substituierte aromatische Reste sind 1.3- oder 1,4-Phenylen, 2,4- oder 2,7-Naphthylen, 4,4'-Diphenylen, 4,4'-Diphenylenmethan, 4,4'-Diphenylenether, 4-Methyl-1,3-phenylen, 4-Ethyl-1,3-phenylen, 2-Methyl-1,3-phenylen, 4-Benzyl-1,3-phenylen, 4-Methoxymethyl-1,3-phenylen, Tetrahydro-1,3-oder -1,4-naphthylen, 3-Propyl-1,3- oder -1,4-phenylen, 3-Isopropyl-1,4-phenylen, 3,5-Dimethyl-1,4-phenylen, 2,4-Dimethyl-1,3-phenylen, 2,3-Dimethyl-1,4-phenylen, 5-Methyl-1,3-phenylen, 2,3,5,6-Tetramethyl-1,4- oder -1,3-phenylen, 3-Methyl-2,6-pyridylen, 3,5-dimethyl-2,6-pyridylen, 3-Ethyl-2,6-pyridylen, 1-Methyl-2,7-naphthylen, 1,6-Dimethyl-2,7-naphthylen, 1-Methyl-2,4-naphthylen, 1,3-Dimethyl-2,4-naphthylen, die zweiwertigen Reste von 5-Amino-1-(3'-amino-4'-methylphenyl)-1,3,3-trimethylindan oder 6-Amino-5-methyl-1-(3'-amino-4'-methyl)-1,3,3-trimethylindan, 4-Methoxymethyl-1,3-phenylen, 3-Methyl-p-diphenylen, 3-Ethyl-p-diphenylen, 3,3'-Dimethyl-p-diphenylen, 3,3'-Diethyl-p-diphenylen, 3-Methyl-3'-ethyl-p-diphenylen, 3,3',5,5'-Tetramethyl-diphenylen, 3,3'-Methyl-5,5'-ethyl-p-diphenylen, 4,4'-Dimethyl-m-diphenylen, 3,3'-Diisopropyldiphenylen, Reste der Formeln

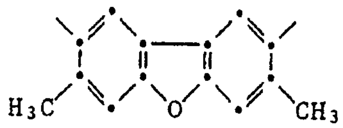
,
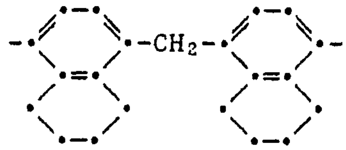
,

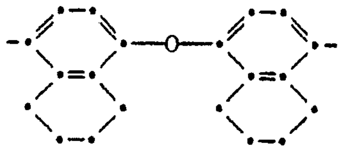

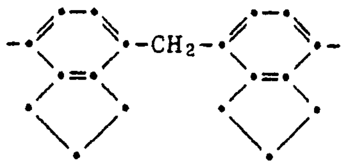
,

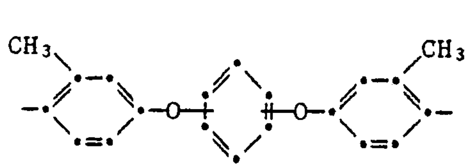
,
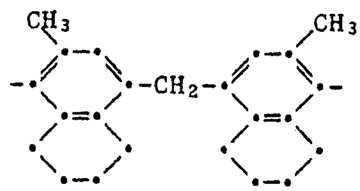
,

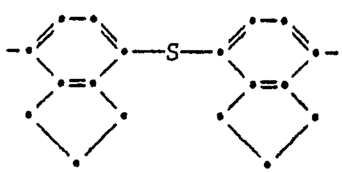
,
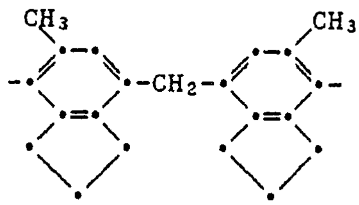
,

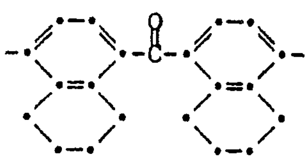
,
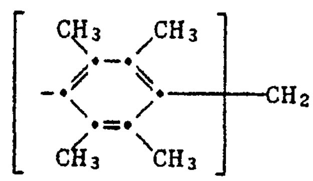

sowie

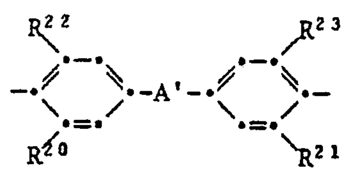
,
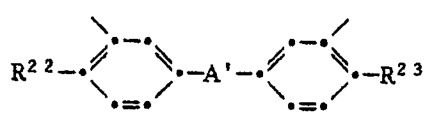

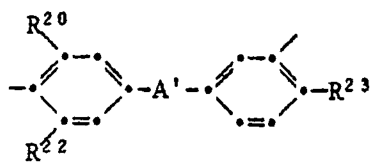
,
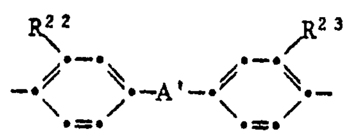

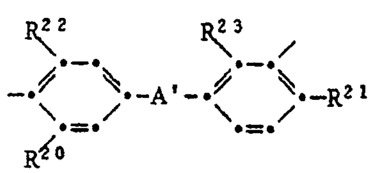
, und
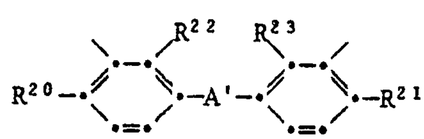
,

worin A', $R^{22}$, $R^{23}$, $R^{20}$ und $R^{21}$ die in nachfolgender Tabelle angegebenen Bedeutungen haben. Die drei vierfach substituierten Reste der voranstehenden Formeln können in jedem Kern durch Reste G und/oder H substituiert sein, wobei G und H die Bedeutung von $R^{22}$ haben können.

| A' | $R^{22}$ | $R^{23}$ | $R^{20}$ | $R^{21}$ |
|---|---|---|---|---|
| $CH_2$ | Methyl | Methyl | - | - |
| $CH_2$ | Methyl | Ethyl | - | - |
| $CH_2$ | Ethyl | Ethyl | - | - |
| $CH_2$ | Isopropyl | Isopropyl | - | - |
| $CH_2$ | Methoxymethyl | | | |
| $CH_2$ | Benzyl | Benzyl | - | - |
| $CH_2$ | Methyl | Methyl | H | H |
| $CH_2$ | Ethyl | Ethyl | H | H |
| $CH_2$ | Isopropyl | Isopropyl | H | H |
| $CH_2$ | Methoxymethyl | | H | H |
| $CH_2$ | Methyl | Ethyl | H | H |
| $CH_2$ | Methoxymethyl | | Methoxymethyl | |
| $CH_2$ | Methyl | Methyl | Methyl | Methyl |
| $CH_2$ | Ethyl | Ethyl | Ethyl | Ethyl |
| $CH_2$ | Methyl | Methyl | Ethyl | Ethyl |
| $CH_2$ | Ethyl | Ethyl | Isopropyl | Isopropyl |
| $CH_2$ | Isopropyl | Isopropyl | Isopropyl | Isopropyl |
| $CH_2$ | Isopropyl | Isopropyl | H | H |
| $CH_2$ | Methoxy | Methoxy | H | H |
| O | Methyl | Methyl | - | - |
| O | Ethyl | Ethyl | - | - |
| O | Methyl | Methyl | H | H |
| O | Methyl | Methyl | Methyl | Methyl |
| O | Methyl | Methyl | Ethyl | Ethyl |
| S | Methyl | Methyl | - | - |
| S | Ethyl | Ethyl | - | - |
| S | Methyl | Methyl | H | H |
| S | Methyl | Methyl | Methyl | Methyl |
| S | Ethyl | Ethyl | Ethyl | Ethyl |
| S | Methyl | Methyl | Ethyl | Ethyl |
| CO | Methyl | Methyl | - | - |
| CO | Methyl | Methyl | H | H |

| A' | $R^{22}$ | $R^{23}$ | $R^{20}$ | $R^{21}$ |
|---|---|---|---|---|
| CO | Methyl | Methyl | Methyl | Methyl |
| $SO_2$ | Methyl | Methyl | - | - |
| $SO_2$ | Methyl | Methyl | H | H |
| $SO_2$ | Methyl | Methyl | Methyl | Methyl |
| $SO_2$ | Ethyl | Ethyl | Methyl | Methyl |
| SO | Methyl | Methyl | - | - |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | - | - |
| $NCH_3$ | Methyl | Methyl | Methyl | Methyl |
| CONH | Methyl | Methyl | - | - |
| NH | Ethyl | Ethyl | H | H |
| NH | Methyl | Methyl | - | - |
| Si(Methyl)$_2$ | Methyl | Methyl | - | - |
| Si(Phenyl)$_2$ | Methyl | Methyl | Methyl | Methyl |
| Si(OMethyl)$_2$ | Ethyl | Ethyl | - | - |
| Si(OPhenyl)$_2$ | Methyl | Methyl | H | H |
| Ethylen | Methyl | Methyl | - | - |
| Ethylen | Methyl | Methyl | Methyl | Methyl |
| Ethylen | Ethyl | Ethyl | H | H |
| Ethylen | Methyl | Methyl | - | - |
| Phenylen | H | H | Methyl | Methyl |
| Phenylen | Ethyl | Ethyl | - | - |
| $(CH_3)_2C<$ | Methyl | Methyl | H | H |
| $(CH_3)_2C<$ | Methyl | Methyl | Methyl | Methyl |

Die erfindungsgemäss zu verwendenden Polyamidsäureester können mittlere Molekulargewichte (Gewichtsmittel $\overline{M}$ w) von mindestens 2 000, vorzugsweise mindestens 5 000 aufweisen. Die obere Grenze richtet sich im wesentlichen nach den gewünschten Eigenschaften, wie zum Beispiel deren Verarbeitbarkeit oder deren Löslichkeit. Sie kann bis zu 500.000, vorzugsweise bis zu 100.000 und besonders bis zu 50.000 betragen. Bei den Copolymeren kann es sich ferner um statistische Polymere oder um Blockpolymere handeln. Sie werden nach üblichen Verfahren in hierfür vorgesehenen Einrichtungen hergestellt.

Die Ausgangsverbindungen zur Herstellung der Polyamidsäureester sind bekannt, käuflich erhältlich

oder nach bekannten Verfahren herstellbar. Tetracarbonsäuren mit Strukturelementen der Formeln V und VI sind in der GB-PS 1 222 630, FR-PS 1 601 094 und 1 565 700 beschrieben.

Die Aminocarbonsäuren mit substituierten Strukturelementen II sind neu. Sie sind z.B. auf folgende Weise erhältlich:

Trimellitsäure-n-butylimid wird mit $SO_2Cl_2$ in

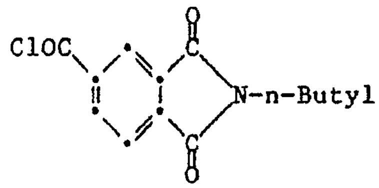

überführt und in Gegenwart von $AlCl_3$ mit

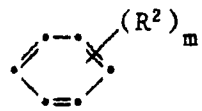

zu

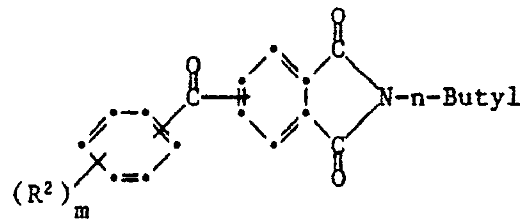

umsetzt. Diese Verbindung wird mit $NHO_3$ nitriert und die gebildete Nitroverbindung katalytisch zur gewünschten Aminoverbindung

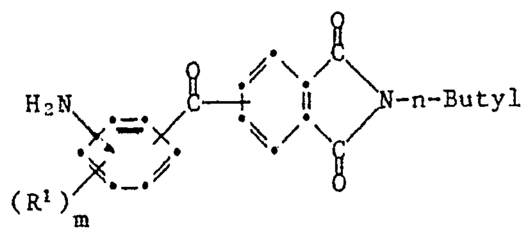

hydriert. Das Imid kann in bekannter Weise in seine Säurederivate umgewandelt werden.

4,4'-Ketobis-(naphthalindicarbonsäure) ist durch die Umsetzung von 2 Mol Dimethylnaphthalin mit $COCl_2$ in Gegenwart von $AlCl_3$ und die anschliessende Oxidation des gebildeten 4,4'-Detobis-(dimethylnaphthalins) mit $HNO_3$ zur Tetracarbonsäure erhältlich. Diese Tetracarbonsäure kann partiell zur 4,4'-Keto-(tetrahydronaphthalindicarbonsäure) hydriert werden. Die Hydrierung kann auch vor der Oxidation mit 4,4'-Ketobis(dimethylnaphthalin) vorgenommen werden.

Tetracarbonsäuren mit Strukturelementen Z, besonders solche der Formel VII sind teilweise bekannt.

Antrachinontetracarbonsäuren sind z.B. im US-Patent 3 702 318 und CA 100,1006119a (1984) beschrieben.

Durch Hydrierung der Ketogruppen in Anthrachinontetracarbonsäuren mit z.B. $NaBH_4$ erhält man die entsprechende Dihydroxyverbindung, die durch Behandlung mit Salzsäure am Rückfluss in Anthrontetracarbonsäure überführt werden kann. Die $CH_2$-Gruppe der Anthrontetracarbonsäure kann in bekannter Weise alkyliert und so in die $CHR^{x}$- bzw. $CR^{x} R^{y}$ -Gruppe überführt werden.

Zur Herstellung von Fluorenontetracarbonsäure kann man z.B. 3,4-Dimethylmagnesiumbromid in Gegenwart von $CuCl_2$ dimerisieren und das gebildete 3,3',4,4'-Tetramethylbiphenyl mit $COCl_2$ in Gegenwart von $AlCl_3$ zum Tetramethylfluorenon umsetzen, das in bekannter Weise mit z.B. $NHO_3$ zur Tetracarbonsäu-

re oxidiert werden kann.

Xanthontetracarbonsäure erhält man, indem man zunächst 3,3',4'4'-Tetramethylphenylether mit $CCl_4$ in Gegenwart von $AlCl_3$ und anschliessender Hydrolyse mit verdünnter HCl zu 2,3,6,7-Tetramethylxanthon umsetzt, das in üblicher Weise zur Tetracarbonsäure oxidiert wird, z.B. mit $NHO_3$.

Tetracarbonsäure mit Strukturelementen der Formeln VII, worin X S, SO, $SO_2$ oder $NR^x$ bedeutet, sind auf folgendem Weg erhältlich:
1-Brom-3,4-dimethylbenzol wird mit $CCl_4$ in Gegenwart von $AlCl_3$ zum Bis-(2-Brom-3,4-dimethylphenyl)-dichlormethan umgesetzt.

Die Oxidation mit 20%-iger $HNO_3$ führt zu

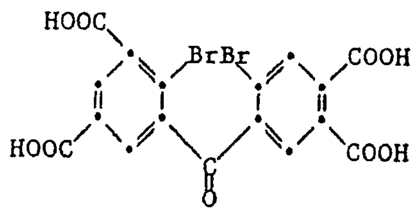

.

Die Umsetzung mit $Na_2S$ ergibt die Thioxanthontetracarbonsäure, die in bekannter Weise zum Sulfoxid bzw. Sulfon oxidiert werden kann. Die Umsetzung mit $NaNH_2$ oder $R^xNH_2$ führt zu den Acridontetracarbonsäuren.

Aminodicarbonsäuren mit Strukturelementen der Formel IV und Diamine $H_2NRNH_2$ sowie Tetracarbonsäuren mit Strukturelementen Z' sind bekannt, käuflich erhältlich oder nach bekannten Verfahren herstellbar. Si-haltige Diamine mit der

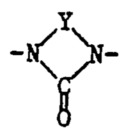

Gruppe können aus den in der DE-A 2 318 170 beschriebenen Diisocyanaten hergestellt werden. Alkyl- oder Cycloalkyl substituierte, besonders Ethyl oder Propyl substituierte Diamine sind durch Alkylierung von unsubstituierten oder teilsubstituierten aromatischen Diamine mit Alkenen bzw. Cycloalkenen zugänglich (vgl. US-PS 3 275 690). Mehrkernige, besonders zweikernige aromatische Diamine sind über die Kondensation entsprechender Monoamine mit Aldehyden oder Ketonen erhältlich.

Die Herstellung von Polyamidsäuren erfolgt in bekannter Weise aus entsprechenden Tetracarbonsäuren bzw. deren Anhydriden und Diaminen zweckmäßig in Lösung bei Temperaturen von z.B. -30 °C bis 100 °C. Die freien Carboxylgruppen können nach verschiedenen Methoden verestert werden:
a) mit Dialkylsulfaten in Gegenwart von Alkalicarbonaten, z.B. $K_2CO_3$,
b) mit Alkyl- oder Aralkylhalogeniden in Gegenwart von 1,8-Diazabicyclo[5.4.0]undecen(7),
c) mit Alkylenoxiden und
d) durch Umesterung von Polyamidsäureestern.

Die Polyamidsäureester sind auch direkt erhältlich durch Umsetzung von Tetracarbonsäurediesterdihalogeniden mit Diaminen, die ihrerseits durch Veresterung von Dianhydriden und anschliessender Chlorierung der gebildeten Carboxylgruppen hergestellt werden können.

Bei den Polyamidsäureestern handelt es sich um Polymere, die direkt durch Einwirkung von Strahlung vernetzt werden können. Sie eignen sich zur Herstellung von Folien, Fasern und zur Beschichtung von Substraten, für den Oberflächenschutz oder zur Erzeugung von Reliefabbildungen, wobei durch Bestrahlung die Eigenschaften der Polykondensate modifiziert werden können.

Ein bevorzugter Anwendungsbereich ist die Verwendung des erfindungsgemässen Materials zur Herstellung von Schutzschichten und Reliefabbildungen auf solchen beschichteten Substrate, was ein weiterer Gegenstand vorliegender Erfindung ist. Es ist besonders vorteilhaft, dass zur Erzielung gewünschter Eigenschaften die erfindungsgemässen Polykondensate für bestimmte Anforderungen bei der Anwendung durch Auswahl unterschiedlicher Monomerer und/oder durch Abmischung verschiedener Polyamidsäureester entsprechend eingestellt werden können. Ferner sind die Polyamidsäureester leicht löslich,was bei der Verarbeitung Vorteile hat.

Zur Herstellung des erfindungsgemässen beschichteten Materials löst man einen Polyamidsäureester oder Gemische davon zweckmässig in einem geeigneten organischen Lösungsmittel, gegebenenfalls unter

Erwärmung. Geeignete Lösungsmittel sind z.B. polare, aprotische Lösungsmittel, die alleine oder in Mischungen aus mindestens zwei Lösungsmittel verwendet werden können. Beispiele sind: Ether wie Dibutylether, Tetrahydrofuran, Dioxan, Ethylenglykol, Dimethylethylenglykol, Dimethyldiethylenglykol, Diethyldiethylenglykol, Dimethyltriethylenglykol, halogenierte Kohlenwasserstoffe wie Methylenchlorid, Chloroform, 1,2-Dichlorethan, 1,1,1,-Trichlorethan, 1,1,2,2-Tetrachlorethan, Carbonsäureester und Lactone wie Essigsäureethylester, Propionsäuremethylester, Benzoesäureethylester, 2-Methoxyethylacetat, γ-Butyrolacton, o-Valerolacton und Pivalolacton, Carbonsäureamide und Lactame wie Formamid, Acetamid, N-Methylformamid, N,N-Dimethylformamid, N,N-Diethylformamid, N,N-dimethylacetamid, N,N-Diethylacetamid, γ-Butyrolactam, ε-Caprolactam, N-Methylpyrrolidon, N-Acetylpyrrolidon, N-Methyl caprolactam, Tetramethylharnstoff, Hexamethylphosphorsäuretriamid, Sulfoxide wie Dimethylsulfoxid, Sulfone wie Dimethylsulfon, Diethylsulfon, Trimethylensulfon, Tetramethylensulfon, Trimethylamin, Triethylamin, N-Methylpyrrolidon, N-Methylpiperidin, N-Methylmorpholin, substituierte Benzole wie Chorbenzol, Nitrobenzol, Phenole oder Kresol.

Ungelöste Anteile können durch Filtration, bevorzugt einer Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung. Die Lösungen sind lagerstabil.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente und Haftvermittler. Ferner können auch falls erwünscht zusätzlich Sensibilisatoren einverleibt werden, um die Lichtempfindlichkeit noch weiter zu erhöhen.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metalllegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca. 500 µm und mehr, bevorzugt von 0,5 bis 500 µm und besonders von 1 bis 50 µm aufweisen.

Die strahlungsempfindliche Schicht im erfindungsgemässen Material kann durch Einwirkung von Strahlung vernetzt werden.

Die Photostrukturierung bzw. Photovernetzung kann durch energiereiche Strahlung hervorgerufen werden, z.B. durch Licht insbesondere im UV-Bereich, durch Röntgenstrahlen, Laserlicht, Elektronenstrahlen usw. Das erfindungsgemässe Material eignet sich hervorragend zur Herstellung von Schutzfilmen, Passivierlacken, und als photographisches Aufzeichnungsmaterial für thermostabile Reliefabbildungen.

Ein weiterer Gegenstand der Erfindung ist diese Verwendung. Anwendungsgebiete sind z.B. Schutz-, Isolier- und Passivierlacke in der Elektrotechnik und Elektronik, Photomasken für die Elektronik, den Textildruck und das graphische Gewerbe, Aetzresiste zur Herstellung gedruckter Schaltungen und Druckplatten und integrierter Schaltkreise, Relais für die Herstellung von Röntgenmasken, als Lötstopplack, als Dielektrium für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten. Gegebenenfalls kann sich eine thermische Nachbehandlung anschliessen.

Die photographische Erzeugung der Reliefstruktur erfolgt durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Die thermische Nachbehandlung wird vorteilhaft bei Temperaturen von 150 bis 450 °C, bevorzugt 200 bis 400 °C vorgenommen. Hierbei wird der Polyamidsäureester in das entsprechende Polyimid überführt. Hierdurch erhält man die vorteilhaften Eigenschaften der Polyimide.

Ein weiterer Gegenstand der Erfindung ist ein solches Verfahren zum Aufbringen von Schutzschichten und von Reliefstrukturen. Als Entwickler sind z.B. die zuvor erwähnten Lösungsmittel geeignet.

Die Polymerschicht des erfindungsgemässen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch gute Haftfestigkeit und thermische, mechanische und chemische Widerstandsfähigkeit aus. Das Material ist lagerstabil, ist aber vor Lichteinwirkung zu schützen.

Die nachfolgenden Beispiele erläutern die Erfindung näher.

A. Herstellungsbeispiele

Beispiele 1: In einem zylindrischen Gefäss, das mit Rührer, Tropftrichter, Thermometer und je einem Ein- und Ableitungsrohr für Stickstoff ausgestattet ist, werden 2,974 g (0,015 Mol) 4,4'-Diaminodiphenylmethan in 31 ml N,N-Dimethylformamid (DMF) gelöst und die Lösung auf 5° C abgekühlt. In die Lösung werden 4,832 g (0,015 Mol) Benzophenontetracarbonsäuredianhydrid eingebracht. Die Mischung wird unter Stickstoff 3 Stunden lang gerührt, währenddessen man die Temperatur durch Entfernung des Kühlbades auf Raumtemperatur ansteigen lässt.

Nun wird die hochviskose Lösung mit 4,55 g pulverisiertem, trockenem $K_2CO_3$ (0,033 Mol) und 30 ml DMF versetzt. Wenige Minuten später werden 5,1 g Diethylsulfat (0.033 Mol) eingetropft. Mit einem Wasserbad wird das Reaktionsgemisch auf 50° C erwärmt und eine Stunde lang weitergerührt, um die Veresterung möglichst zu vervollständigen.

Nun wird die Lösung unter starkem Rühren in 1 l verdünnte Salzsäure gegossen und so das Polymer ausgefällt, filtriert und mit viel Wasser gewaschen. Nach Trocknung bei 60° C im Vakuum wird an einer Probe der Anteil an noch verbliebenen Carboxylgruppen im Polyamidsäureethylester durch Titration mit Perchlorsäure in wasserfreiem Medium bestimmt. Es ergibt sich ein Veresterungsgrad von 90 %. Daraus berechnet sich

| Elementaranalyse: (für 100 % veresterte Probe) | berechnet (Gew.%) | gefunden (Gew.%) |
|---|---|---|
| C | 70,82 | 70,7 |
| H | 4,90 | 4,1 |
| N | 4,86 | 5,3 |
| O | 19,42 | 19,7 |

Beim Aufheizen einer Probe im DSC (Differential Scanning Calorimeter) ist im ersten Durchlauf eine Endothermie zwischen 250 und 400° C zu verzeichnen, hervorgerufen durch das Verdampfen des bei der Imidisierung abgespaltenen Alkohols.

Im zweiten Durchlauf wird eine Glastemperatur von 265° C gefunden. Diese Temperatur entspricht der Glastemperatur des separat hergestellten Polyimids aus 4,4'-Diaminodiphenylmethan und Benzophenontetracarbonsäuredianhydrid (BTDA).

Die reduzierte Lösungsviskosität des Polyamidsäureesters, gemessen als 0,5-prozentige Lösung in m-Kresol, beträgt: $\eta$ red. = 0,83 dl/g

Beispiele 2-6: Analog Beispiel 1 werden folgende Diamine mit BTDA umgesetzt und anschliessend die dabei entstandene Polyamidsäure mit $K_2CO_3$ und Diethylsulfat verestert.

| Beispiel | Diamin | η red. | Veresterungsgrad (%) |
|---|---|---|---|
| 2 | 3,3'-Dimethyl-5,5'-diethyl-4,4'-diaminodiphenylmethan | 0,76 | 93 |
| 3 | 1,10-Diaminodecan | 0,55 | 90 |
| 4 | 3,3'-Dimethyl-4,4'-diaminodiphenylmethan | 1,14 | 95 |
| 5 | 1-Methyl-2,4-diamino-3,5-diethylbenzol | 0,36 | 96 |
| 6 | 3,3'-Dimethyl-4,4'-diaminodicyclohexylmethan | 0,72 | 96 |

Beispiel 7: Das in Beispiel 2 eingesetzte Diamin wird gemäss Beispiel 1 mit Anthrachinontetracarbonsäuredianhydrid (anstelle von BTDA) zur Polyamidsäure umgesetzt und anschliessend mit $K_2CO_3$ und Diethylsulfat verestert.
$\eta$ red. = 0,21 dl/g (0,5%-ige Lösung in m-Kresol)
Veresterungsgrad: 93 %

Beispiel 8: Beispiel 2 wird wiederholt mit dem Unterschied, dass anstelle von Diethylsulfat die entsprechende Menge Dimethylsulfat zur Veresterung der Polyamidsäure eingesetzut wird und die Veresterung bei 0 °C durchgeführt wird.
$\eta$ red. = 0,98 dl/g (0,5%ige Lösung in m-Kresol)
Veresterungsgrad: 98 %

Beispiel 9: Gemäss Beispiel 1 werden 0,01 Mol 3,3',5,5'-Tetraethyl-4,4'-diaminodiphenylmethan mit 0,01 Mol BTDA in 25 ml DMF zur Polyamidsäure umgesetzt. Nach Verdünnung mit weiteren 25 ml DMF werden 0,02 Mol 1,8 Diazabicyclo[5.4.0]undecen(7) und 0,021 Mol Benzylchlorid zugesetzt. Nach wenigen Minuten wird auf 55 °C aufgeheizt und eine Stunde lang diese Temperatur gehalten. Die Isolierung des Polymeren erfolgt wie in Beispiel 1 beschrieben.
$\eta$ red. = 0,1 dl/g (0,5%-ige Lösung in m-Kresol)
Veresterungsgrad: 53 %

B) Anwendungsbeispiele

Auf einer einseitig Kupfer-kaschierten Kunststoffplatte wird ein dünner Polymerfilm erzeugt, indem eine 5%-ige Polymerlösung aufgeschleudert wird und das Lösungsmittel anschliessend in einem Umluftofen entfernt wird. Als Lösungsmittel wird N-Methylpyrrolidon oder DMF verwendet.

Die so beschichteten Platten werden durch eine Photomaske bei Raumtemperatur mit einer 1 000 Watt-UV-Lampe aus 18 cm Entfernung belichtet. Die belichteten Platten werden anschliessend mit einem Lösungsmittel entwickelt, wobei die unbelichteten Anteile des Polymerfilms weggelöst werden. Die Sichtbarmachung des Reliefbildes geschieht anschliessend durch Wegätzen der freigelegten Kupferschicht mit $FeCl_3$-Lösung.

Die Belichtungszeiten zum Erhalt einer vollständigem Abbildung für die in den Beispielen 1 bis 9 beschriebenen Polymeren betragen:

| Beispiel | 1 | 2 | 3 | 4 | 5 | 6 | 7 | 8 | 9 |
|---|---|---|---|---|---|---|---|---|---|
| Sekunden | 120 | 30 | 120 | 60 | 60 | 60 | 60 | 60 | 120 |

Durch Erhitzen auf etwa 400° C werden die Polyamidsäureester in an sich bekannter Art und Weise in die entsprechenden Polyimide überführt.

## Ansprüche

1. Verfahren zur Herstellung vernetzten po1ren, dadurch gekennzeichnet, dass man Polyamidsäureester enthaltend 50 bis 100 Mol%, bezogen auf den Polyamidsäureester, mindestens eines wiederkekrenden Strukturelementes der Formel I oder II oder Mischungen davon

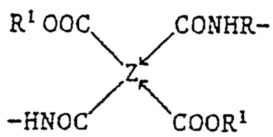 (I) 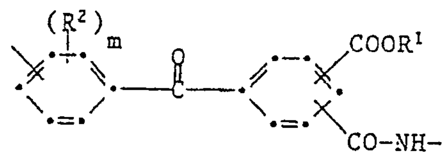 (II)

und 0 bis 50 Mol% mindestens eines wiederkehrenden Strukturelementes der Formeln II oder IV oder Mischungen davon mit energiereicher Strahlung bestrahlt

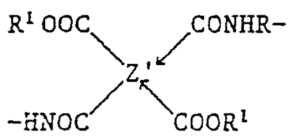 (III) 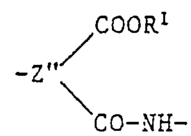 (IV),

worin die Pfeile für Stellungsisomerie stehen, Z einen vierwertigen phenylaromatischen Rest bedeutet, der eine Benzophenonstruktureinheit enthält, bei der je eine der Estergruppen und Amidgruppen in Formel I in Orthostellung entweder an einen Phenylrest oder an zwei verschiedene Phenylreste gebunden sind, und die Ester- und Amidgruppe in Formel II in Orthostellung gebunden sind,
Z' für einen vierwertigen, von Z verschiedenen aromatischen Rest und
Z" für einen dreiwertigen vom Rest der Formel II verschiedenen aromatischen Rest stehen, in denen je eine Ester- und Amidgruppe in Orthostellung oder Peristellung gebunden sind,
R einen unsubstituierten oder substituierten zweiwertigen organischen Rest bedeutet,
$R^1$ einen gesättigten aliphatischen Kohlenwasserstoffrest darstellt, und
$R^2$ für einen Substituenten steht, und m 0 oder eine Zahl von 1-4 bedeutet.

2. Verfahren zur Herstellung von Schutzschichten oder Feliefabbildungen gemäss Anspruch 1 umfassend die Schritte:
i) Beschichten eines Substrates mit einem Polyamidsäureester gemäss Anspruch 1,
ii) direktes oder bildmässiges Belichten der Polymerschicht mit energiereicher Strahlung,
iii) Entwickeln der unbelichteten Anteile mit einem Lösungsmittel oder einem Lösungsmittelgemisch, und
iv) gegebenenfalls thermischer Nachbehandlung, um den polyamidsäureester in das entsprechende Polyimid zu überführen.

3. Beschichtetes Material, bei dem auf mindestens einer Oberfläche eines Trägermaterials eine Schicht mindestens eines Polyamidsäureesters aufgebracht ist, dadurch gekennzeichnet,
dass der Polyamidsäureester mindestens 50 bis 100 Mol%, bezogen auf den Polyamidsäureester, mindestens eines wiederkehrenden Strukturelementes der Formel I oder II gemäss Anspruch 1 oder Mischungen davon und
0 bis 50 Mol% mindestens eines wiederkehrenden Strukturelementes der Formel III oder IV gemäss Anspruch 1 oder Mischungen dar enthält,
worin Z, Z', Z" und $R^1$ die in Anspruch 1 definierte Bedeutung besitzen und
R ein substituierter oder unsubstituierter zweiwertiger aliphatischer, cycloaliphatischer oder araliphatischer Rest oder ein mit Alkyl, Alkoxyalkyl, Alkoxy, Trimethylen oder Tetramethylen substituierter zweiwertiger aromatischer Rest ist.

4. Verfahren gemäss Anspruch 1 oder Material gemäss Anspruch 3, dadurch gekennzeichnet, dass Z den Formeln V, VI oder VII entspricht,

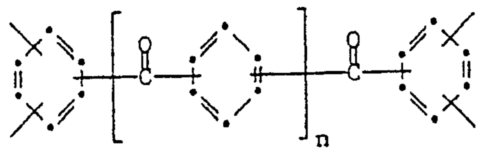 (V),

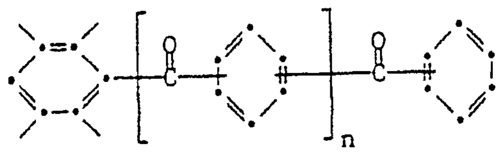 (VI),

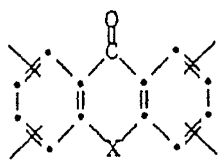 (VII)

worin n für 0 oder 1 und X für eine direkte Bindung, $-CH_2-$, -O-, -S-, -SO-, $-SO_2-$, $-NR^x-$, $-CR^x R^y-$ oder -CO- stehen, die freien Bindungen in Orthostellung gebunden sind, $R^x$ für H oder $C_1$-$C_6$-Alkyl, Phenyl, Benzyl oder Cyclohexyl steht und $R^y$ die Bedeutung von $R^x$ hat aber nicht H ist.

5. Verfahren gemäss Ansprüch 1 oder Material gemäss Anspruch 3, dadurch gekennzeichnet, dass Z den Formeln

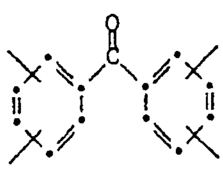 oder 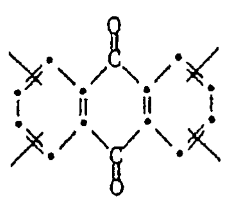 oder 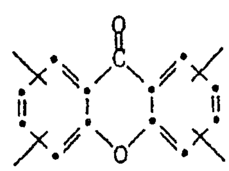

entspricht.

6. Verfahren gemäss Ansprüch 1 oder Material gemäss Anspruch 3, dadurch gekennzeichnet, dass der Rest der Formel II der Formel

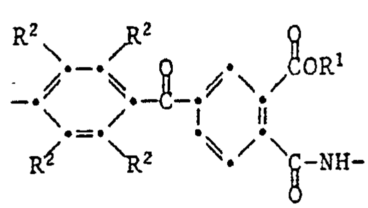

entspricht, worin $R^2$ ein Wasserstoffatom oder Methyl ist.

7. Verfahren gemäss Ansprüch 1 oder Material gemäss Anspruch 3, dadurch gekennzeichnet, dass Z' in Formel III dem Rest

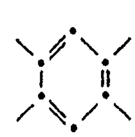

entspricht.

**8.** Verfahren gemäss Ansprüch 1 oder Material gemäss Anspruch 3, dadurch gekennzeichnet, dass der Rest der Formel IV den Formeln

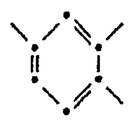 , 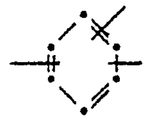 oder 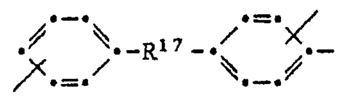

entspricht, worin $R^{17}$ eine direkte Bindung oder eine Brückengruppe ist, und die freien Bindungen in Orthostellung gebunden sind.

**9.** Verfahren gemäss Ansprüch 1 oder Material gemäss Anspruch 3, dadurch gekennzeichnet, dass $R^2$ $C_1$-$C_4$-Alkyl und m 1, 2, 3 oder 4 bedeuten.

**10.** Verfahren gemäss Ansprüch 1 oder Material gemäss Anspruch 3, dadurch gekennzeichnet, dass $R^1$ unsubstituiertes oder substituiertes, lineares oder verzweigtes Alkyl, Cycloalkyl oder Aralkyl ist.

**11.** Verfahren oder Material gemäss Anspruch 10, dadurch gekennzeichnet, dass $R^1$ $C_1$-$C_{12}$-Alkyl, Cycloalkyl mit 5 oder 6 Ring-C-Atomen oder Aralkyl mit 1 oder 2 C-Atomen in der Alkylengruppe ist.

**12.** Verfahren oder Material gemäss Anspruch 11, dadurch gekennzeichnet, dass $R^1$ $C_1$-$C_4$-Alkyl oder Benzyl ist.

**13.** Verfahren gemäss Anspruch 1, dadurch gekennzeichnet, dass R einen unsubstituierten oder substituierten zweiwertigen aliphatischen, cycloaliphatischen, araliphatischen oder aromatischen Rest bedeutet.

**14.** Verfahren gemäss Anspruch 1, dadurch gekennzeichnet, dass R als aliphatischer Rest 2 bis 30 C-Atome, als cycloaliphatischer Rest 5 bis 8 Ring-C-Atome, als araliphatischer Rest 7 bis 30 C-Atome und als aromatischer Rest 6 bis 30 C-Atome enthält.

**15.** Verfahren gemäss Anspruch 7, dadurch gekennzeichnet, dass R als aliphatischer Rest lineares oder verzweigtes Alkylen, das durch Sauerstoffatome, $NR^a$ oder $^{\oplus}NR_2^aG^{\ominus}$, worin $R^a$ Alkyl mit 1 bis 12 C-Atomen oder Cycloalkyl mit 5 oder 6 Ring-C-Atomen, Phenyl oder Benzyl ist und $G^{\ominus}$ das Anion einer Protonensäure ist, Cyclohexylen, Naphthylen, Phenylen oder Hydantoine unterbrochen sein kann; als cycloaliphatischer Rest unsubstituiertes oder durch Alkyl substituiertes Mono- oder bicyclisches Cycloalkylen mit 5 bis 7 Ring-C-Atomen; als araliphatischer Rest unsubstituiertes oder am Aryl durch Alkyl substituiertes Aralkylen ist, wobei der Alkylenrest linear oder verzweigt sein kann; und als aromatischer Rest ein unsubstituierter oder durch Alkyl, Alkoxy, Alkoxyalkyl, Trimethylen oder Tetramethylen substituierter Kohlenwasserstoffrest oder Pyridinrest, ist.

**16.** Verfahren gemäss Anspruch 1 oder Material gemäss Anspruch 3, dadurch gekennzeichnet, dass R als aliphatischer Rest lineares oder verzweigtes Alkylen mit 2 bis 30 C-Atomen, $-(CH_2)_x-R^3-(CH_2)_y-$, worin $R^3$ Phenylen, Naphthylen, Cyclopentylen oder Cyclohexylen und x und y unabhängig voneinander die Zahl 1, 2 oder 3 sind, $-R^4-(OR^5)_p-O-R^4-$, worin $R^4$ Ethylen, 1,2-Propylen, 1,3-Propylen oder 2-Methyl-1,3-Propylen und $R^5$ Ethylen, 1,2-Propylen, 1,2-Butylen, 1,3-Propylen, 1,3-Butylen oder 1,4-Butylen und p eine Zahl von 1 bis 100 sind, oder

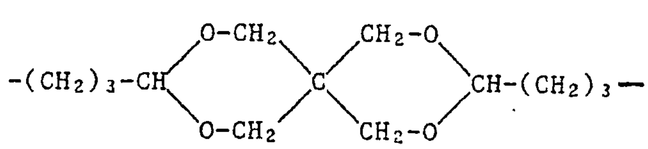

ist.

17. Verfahren gemäss Anspruch 1 oder Material gemäss Anspruch 13, dadurch gekennzeichnet, dass R als cycloaliphatischer Rest solche der Formeln

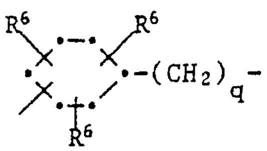

oder

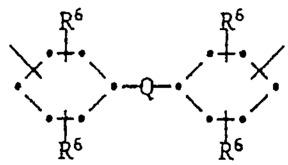

sind, worin q 0 oder 1 ist, die $R^6$ unabhängig Wasserstoff oder Alkyl mit 1 bis 6 C-Atomen bedeuten und Q für eine direkte Bindung, O, S, $SO_2$, Alkylen mit 1 bis 3 C-Atomen oder Alkyliden mit 2 bis 6 C-Atomen steht.

18. Verfahren gemäss Anspruch 1 oder Material gemäss Anspruch 3, dadurch gekennzeichnet, dass R als aromatischer Rest durch Alkyl, Alkoxy oder Alkoxyalkyl mit 1 bis 6 C-Atomen oder zwei benachbarte C-Atome des aromatischen Restes durch Trimethylen oder Tetramethylen substituiert sind.

19. Verfahren oder Material gemäss Anspruch 18, dadurch gekennzeichnet, dass ein oder zwei der Substituenten in Orthostellung zur NH-Gruppe in Formel I gebunden sind.

20. Verfahren gemäss Anspruch 1 oder Material gemäss Anspruch 3, dadurch gekennzeichnet, dass R als aliphatischer Rest der Formel

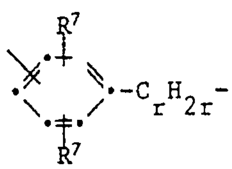

entspricht, worin die $R^7$ unabhängig ein Wasserstoffatom oder Alkyl mit 1 bis 6 C-Atomen und r ganze Zahlen von 1 bis 16 bedeuten.

21. Verfahren oder Material gemäss Anspruch 20, dadurch gekennzeichnet, dass die freie Bindung in p-Stellung zur $C_rH_{2r}$-Gruppe steht und ein oder beide $R^7$ als Alkyl in o-Stellung zur freien Bindung gebunden sind.

22. Verfahren gemäss Anspruch 15, dadurch gekennzeichnet, dass der aromatische Rest den Formeln

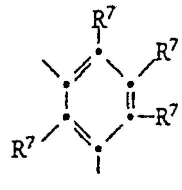 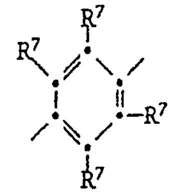 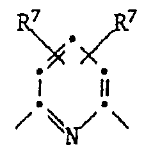

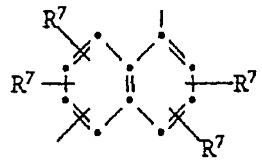 , 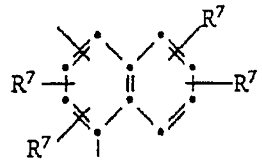 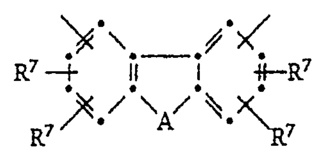

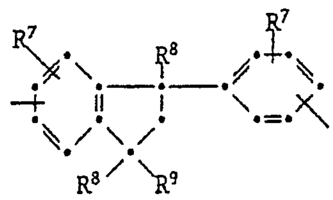 oder 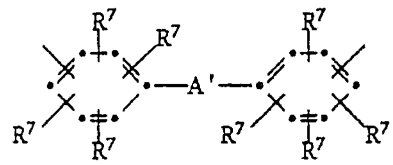

entspricht,
worin alle $R^7$ ein Wasserstoffatom, $R^7$ im Falle der Monosubstitution Alkyl mit 1 bis 6 C-Atomen und die anderen $R^7$ Wasserstoffatome sind, und im Falle der Di-, Tri- oder Tetrasubstitution zwei $R^7$ Alkyl mit 1 bis 6 C-Atomen und die anderen $R^7$ ein Wasserstoffatom oder Alkyl mit 1 bis 6 C-Atomen sind oder im Falle der Di-, Tri- opder Tetrasubstitution zwei vicinale $R^7$ im Phenylring für Trimethylen oder Tetramethylen und die anderen $R^7$ für ein Wasserstoffatom oder Alkyl mit 1 bis 6 C-Atomen stehen, A für O, S, NH, CO oder $CH_2$ steht, $R^8$ ein Wasserstoffatom oder Alkyl mit 1 bis 5 C-Atomen und $R^9$ Alkyl mit je 1 bis 5 C-Atomen darstellt, und $A^1$ eine direkte Bindung, O, S, $SO_2$, CO,

$$\overset{O}{\overset{\|}{C}}O,\ \overset{O}{\overset{\|}{C}}NR^{10},$$

$NR^{10}$, CONH, NH, $R^{10}SiR^{11}$, $R^{10}OSiOR^{11}$, Alkylen mit 1 bis 6 C-Atomen oder Alkyliden mit 2 bis 6 C-Atomen, Phenylen oder Phenyldioxyl bedeutet, worin $R^{10}$ und $R^{11}$ unabhängig voneinander Alkyl mit 1 bis 6 C-Atomen oder Phenyl bedeuten.

**23.** Verfahren gemäss Anspruch 22 oder Material gemäss Anspruch 3, dadurch gekennzeichnet, dass R einem aromatischen Rest der Formeln

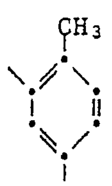 , 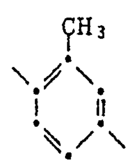 , 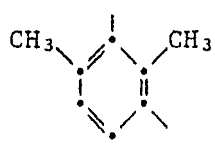 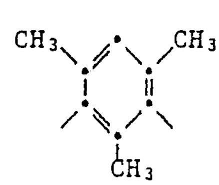

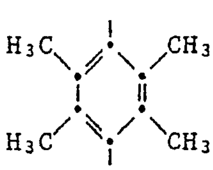 , 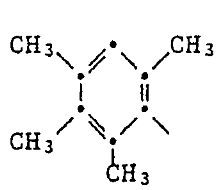 oder 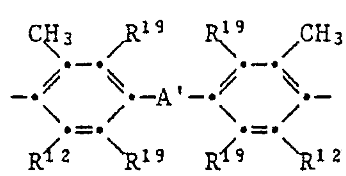

entspricht,
worin A' eine direkte Bindung, O und besonders $CH_2$ bedeutet und $R^{12}$ ein Wasserstoffatom und besonders Methyl oder Ethyl darstellt und $R^{19}$ für ein Wasserstoffatom und besonders Methyl oder

Ethyl steht.

24. Verfahren gemäss Anspruch 1 oder Material gemäss Anspruch 3, dadurch gekennzeichnet, dass bis zu 50 Mol-% der Komponente (a) oder (b) durch die entsprechende Polyamidsäure ersetzt ist.

25. Verwendung des polyamidsäureesters gemäss Anspruch 1 zur Herstellung von Schutzschichten oder photographischen Abbildungen durch Bestrahlen; gegebenenfalls durch eine Photomaske, anschliessendes Entfernen der nicht bestrahlten Anteile des Polykondensates; und thermisches Behandeln der Schicht bzw. der Abbildung zur Ueberführung der Polyamidsäureester in ein Polyimid.

## Claims

1. A process for the preparation of crosslinked polymers, which comprises irradiating a poly(amido ester) containing 50 to 100 mol %, based on the poly(amido ester), of at least one recurring structural element of formula I or II or mixtures thereof

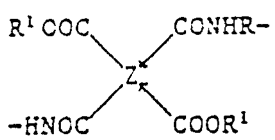 (I) 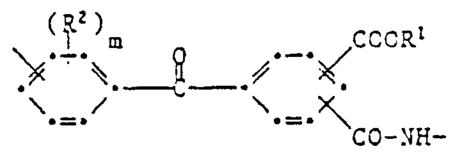 (II)

and 0 to 50 mol % of at least one recurring structural element of formulae III or IV or mixtures thereof with high-energy radiation

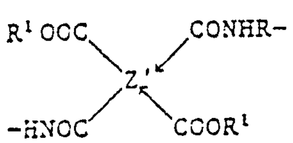 (III) 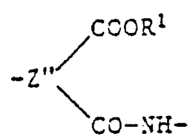 (IV),

in which the arrows denote position isomerism, Z is a tetravalent phenyl-aromatic radical which contains a benzophenone structural unit and in which one of the ester groups and one of the amide groups in formula I are attached in the ortho-position either to one phenyl radical or to two different phenyl radicals, and the ester and amide groups in formula II are attached in the ortho-position,
Z' is a tetravalent aromatic radical which differs from Z and
Z" is a trivalent aromatic radical which differs from the radical of formula II, in which one ester group and one amide group are attached in the ortho- or peri-position,
R is an unsubstituted or substituted divalent organic radical, $R^1$ is a saturated aliphatic hydrocarbon radical, and
$R^2$ is a substituent, and
m is 0 or a number from 1 to 4.

2. A process for producing protective layers or relief images according to claim 1, comprising the steps:
i) coating a substrate with a poly(amido ester) according to claim 1,
ii) direct or imagewise exposure of the polymer layer with high-energy radiation,
iii) developing the unexposed portions with a solvent or a solvent mixture, and
iv) if desired, thermal aftertreatment, in order to convert the poly(amido ester) into the corresponding polyimide.

3. A coated material, in which a layer of at least one poly(amido ester) is applied onto at least one surface of a carrier material, wherein the poly(amido ester) contains at least 50 to 100 mol %, based on the poly(amido ester), of at least one recurring structural element of formula I or II according to claim 1 or mixtures thereof and 0 to 50 mol % of at least one recurring structural element of formula III or IV according to claim 1 or mixtures thereof,
in which z, z', z" and $R^1$ are as defined in claim 1 and R is a substituted or unsubstituted divalent

aliphatic, cycloaliphatic or araliphatic radical or a divalent aromatic radical which is substituted by alkyl, alkoxyalkyl, alkoxy, trimethylene or tetramethylene.

4. A process according to claim 1 or a material according to claim 3, wherein Z has the formula V, VI or VII

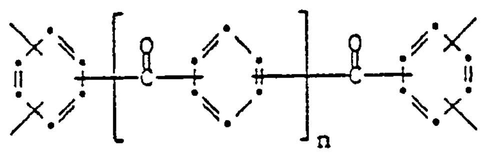

(V),

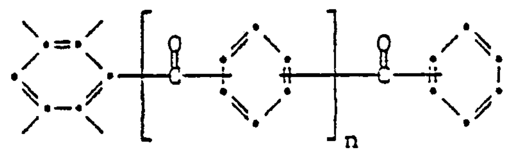

(VI),

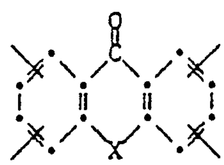

(VII)

in which n is 0 or 1 and X is a direct bond, $-CH_2-$, -O-, -S-, -SO-, $-SO_2-$, $-NR^x-$, $CR^xR^y-$ or -CO-, and the free bonds are attached in the ortho-position, $R^x$ is hydrogen or $C_1$-$C_6$ alkyl, phenyl, benzyl or cyclohexyl, and $R^y$ has the meaning of $R^x$ but is not hydrogen.

5. A process according to claim 1 or a material according to claim 3, wherein Z has the formula

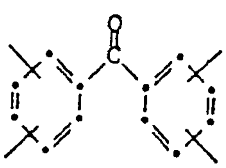

or

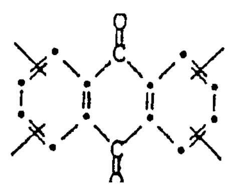

or

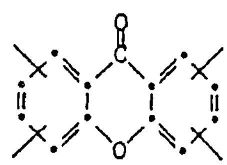

6. A process according to claim 1 or a material according to claim 3, wherein the radical of formula II has the formula

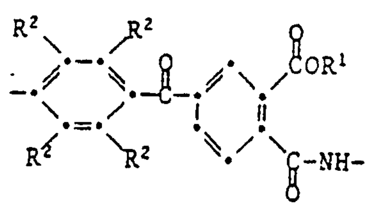

in which $R^2$ is a hydrogen atom or methyl.

7. A process according to claim 1 or a material according to claim 3, wherein Z' in formula III is the radical

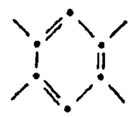

**8.** A process according to claim 1 or a material according to claim 3, wherein the radical of formula IV has the formula

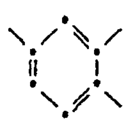 , 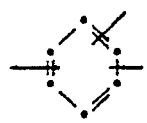 or 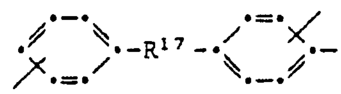

in which $R^{17}$ is a direct bond or a bridge group, and the free bonds are attached in the ortho-position.

**9.** A process according to claim 1 or a material according to claim 3, wherein $R^2$ is $C_1$-$C_4$alkyl and m is 1, 2, 3 or 4.

**10.** A process according to claim 1 or a material according to claim 3, wherein $R^1$ is unsubstituted or substituted, linear or branched alkyl, cycloalkyl or aralkyl.

**11.** A process cr a material according to claim 10, wherein $R^1$ is $C_1$-$C_{12}$alkyl, cycloalkyl of 5 or 6 ring carbon atoms or aralkyl having 1 or 2 carbon atoms in the alkylene group.

**12.** A process or a material according to claim 11, wherein $R^1$ is $C_1$-$C_4$alkyl or benzyl.

**13.** A process according to claim 1, wherein R is an unsubstituted or substituted divalent aliphatic, cycloaliphatic, araliphatic or aromatic radical.

**14.** A process according to claim 1, wherein an aliphatic radical R contains 2 to 30 carbon atoms, a cycloaliphatic radical R contains 5 to 8 ring carbon atoms, an araliphatic radical R contains 7 to 30 carbon atoms or an aromatic radical R contains 6 to 30 carbon atoms.

**15.** A process according to claim 1, wherein an aliphatic radical R is linear or branched alkylene which can be interrupted by oxygen atoms, $NR^a$ or $^{\oplus}NR_2^aG^{\ominus}$, in which $R^a$ is alkyl of 1 to 12 carbon atoms or cycloalkyl of 5 or 6 ring carbon atoms, phenyl or benzyl and $G^{\ominus}$ is the anion of a protic acid, or by cyclohexylene, naphthylene, phenylene or hydantoins;
a cycloaliphatic radical R is monocyclic or bicyclic cycloalkylene which has 5 to 7 ring carbon atoms and is unsubstituted or substituted by alkyl; an araliphatic radical R is aralkylene which is unsubstituted or substituted on the aryl by alkyl, it being possible for the alkylene radical to be linear or branched; or an aromatic radical R is a hydrocarbon radical or a pyridine radical, which is unsubstituted or substituted by alkyl, alkoxy, alkoxyalkyl, trimethylene or tetramethylene.

**16.** A process according to claim 1 or a material according to claim 3, wherein an aliphatic radical R is linear or branched alkylene of 2 to 30 carbon atoms, $-(CH_2)_x-R^3-(CH_2)_y-$, in which $R^3$ is phenylene, naphthylene, cyclopentylene or cyclohexylene and x and y are each independently of the other the number 1, 2 or 3, or $-R^4-(OR^5)_p-O-R^4-$, in which $R^4$ is ethylene, 1,2-propylene, 1,3-propylene or 2-methyl-1,3-propylene, $R^5$ is ethylene, 1,2-propylene, 1,2-butylene, 1,3-propylene, 1,3-butylene or 1,4-butylene and p is a number from 1 to 100, or

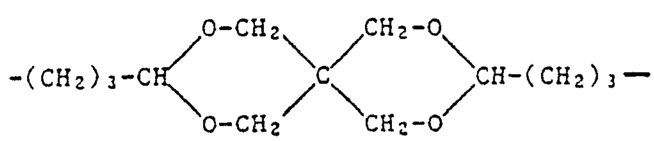

**17.** A process according to claim 1 or a material according to claim 3, wherein a cycloaliphatic radical R is a radical of formula

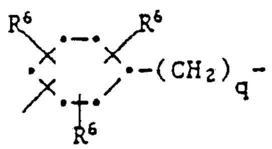

or

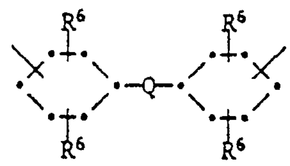

in which q is 0 or 1, each $R^6$ is independently hydrogen or alkyl of 1 to 6 carbon atoms and Q is a direct bond, O, S, $SO_2$, alkylene of 1 to 3 carbon atoms or alkylidene of 2 to 6 carbon atoms.

**18.** A process according to claim 1 or a material according to claim 3, wherein an aromatic radical R is substituted by alkyl, alkoxy or alkoxyalkyl, each of 1 to 6 carbon atoms, or two adjacent carbon atoms of the aromatic radical are substituted by trimethylene or tetramethylene.

**19.** A process or a material according to claim 18, wherein one or two of the substituents are attached in the ortho-position to the NH group in formula I.

**20.** A process according to claim 1 or a material according to claim 3, wherein an aliphatic radical R has the formula

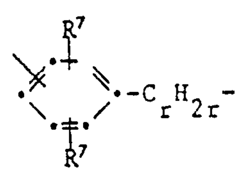

in which $R^7$ independently is a hydrogen atom or alkyl of 1 to 6 carbon atoms and each r is an integer from 1 to 16.

**21.** A process or a material according to claim 20, wherein the free bond is in the para-position to the $C_rH_{2r}$ group and one $R^7$ or each $R^7$ as alkyl is attached in the ortho-position to the free bond.

**22.** A process according to claim 15, wherein the aromatic radical has the formula

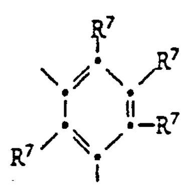

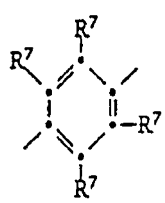

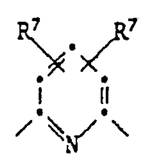

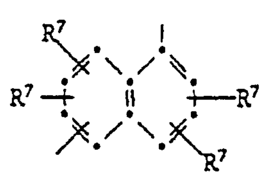

,

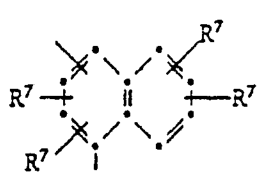

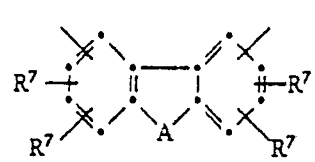

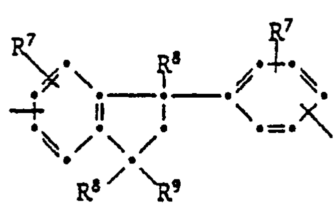

or

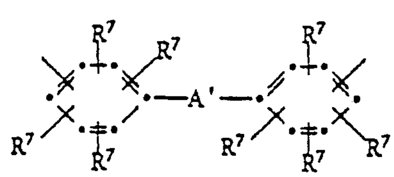

in which each $R^7$ is a hydrogen atom and, in the case of monosubstitution, one substituent $R^7$ is alkyl of 1 to 6 carbon atoms and the other substituents $R^7$ are hydrogen atoms, and in the case of di-, tri- or tetra-substitution, two substituents $R^7$ are alkyl of 1 to 6 carbon atoms and the other substituents $R^7$ are hydrogen atoms or alkyl of 1 to 6 carbon atoms, or in the case of di-, tri- or tetra-substitution, two vicinal substituents $R^7$ in the phenyl ring are trimethylene or tetramethylene and the other substituents $R^7$ are hydrogen atoms or alkyl of 1 to 6 carbon atoms, A is O, S, NH, CO or $CH_2$, $R^8$ is a hydrogen atom or alkyl of 1 to 5 carbon atoms, $R^9$ is alkyl of in each case 1 to 5 carbon atoms and A' is a direct bond, O, S, $SO_2$, CO,

$$\overset{\overset{O}{\|}}{C}O,\ \overset{\overset{O}{\|}}{C}NR^{10},\ NR^{10},\ CONH,\ NH,\ R^{10}SiR^{11},\ R^{10}OSiOr^{11},$$

alkylene of 1 to 6 carbon atoms or alkylidene of 2 to 6 carbon atoms, phenylene or phenyldioxyl, in which $R^{10}$ and $R^{11}$ are each independently of the other alkyl of 1 to 6 carbon atoms or phenyl.

**23.** A process according to claim 22 or a material according to claim 3, wherein R is an aromatic radical of formula

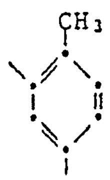 , 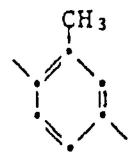 , 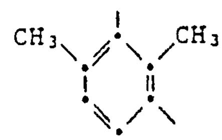 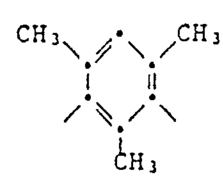

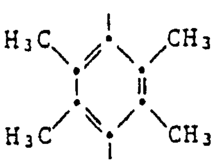 , 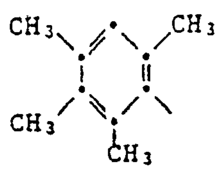 or 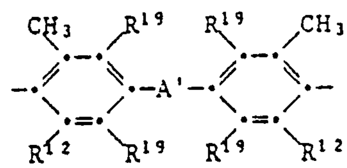

in which A' is a direct bond, O and particularly $CH_2$, and $R^{12}$ is a hydrogen atom and particularly methyl or ethyl, and $R^{19}$ is a hydrogen atom and particularly methyl or ethyl.

**24.** A process according to claim 1 or a material according to claim 3, wherein up to 50 mol % of component (a) or (b) is replaced by the corresponding poly(amido acid).

**25.** The use of the poly(amido ester) according to claim 1 for producing protective layers or photographic images by irradiation, if desired through a photomask, subsequent removal of the non-irradiated portions of the polycondensate, and heat treatment of the layer or of the image in order to convert the poly(amido ester) into a polyimide.

## Revendications

**1.** Procédé pour préparer des polymères réticulés, procédé caractérisé en ce qu'on irradie par un rayonnement de haute énergie des polyamide-acide-esters contenant de 50 à 100 % en moles, par rapport au polyamide-acide-ester, d'au moins une unité structurale répétée répondant à l'une des formules I et II ou de mélanges de celles-ci :

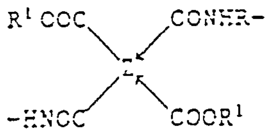

(I)

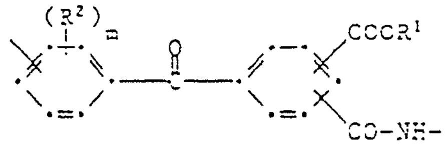

(II)

et de 0 à 50% en moles d'au moins une unité structurale répétée répondant à l'une des formules III et IV ou de mélanges de celles-ci :

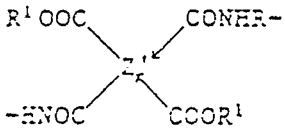

(III)

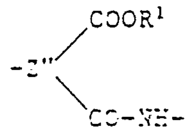

(IV),

formules dans lesquelles :

les flèches expriment l'existence d'une isomérie de position,

Z représente un radical aromatique phénylique quadrivalent qui contient une unité structurale de benzophénone dans laquelle à chaque fois un des radicaux esters et un des radicaux amides, dans la formule I, sont fixés en position ortho soit sur un radical phényle soit sur deux radicaux phényles différente, et les radicaux ester et amide, dans la formule II, sont liés en position ortho,

Z' représente un radical aromatique quadrivalent qui est différent de Z,

Z" représente un radical aromatique trivalent différent du radical de formule II et dans lequel un radical ester et un radical amide sont liés en position ortho ou en position péri,

R représente un radical organique bivalent, substitué ou non,

$R^1$ représente un radical hydrocarboné aliphatique saturé,

$R^2$ représente un substituant et

m désigne un nombre de 0 à 4.

**2.** Procédé pour préparer des couches protectrices et des images en relief selon la revendication 1, procédé qui comporte les étapes suivantes :

i) on enduit un substrat avec un polyamide-acide-ester selon la revendication 1,

ii) on irradie avec un rayonnement de haute énergie, directement ou conformément à une image, la couche de polymère,

iii) on développe en éliminant au moyen d'un solvant ou d'un mélange solvant les parties qui n'ont pas été touchées par le rayonnement et

iv) on effectue ensuite éventuellement un traitement complémentaire par la chaleur pour transformer le polyamide-acide-ester en le polyimide correspondant.

**3.** Matière revêtue comportant une couche d'au moins un polyamide-acide-ester appliquée sur au moins une surface d'un support, matière caractérisée en ce que le polyamide-acide-ester contient de 50 à 100 % en moles, par rapport au polyamide-acide-ester d'au moins une unité structurale répétée de formule I ou II selon la revendication 1, ou de mélanges de celles-ci, et de 0 à 50 % en moles d'au moins une unité structurale répétée de formule III ou IV selon la revendication 1 ou de mélanges de celles-ci, formules dans lesquelles Z, Z', Z" et $R^1$ ont les significations qui leur ont été données à la revendication 1, et R représente un radical aliphatique, cycloaliphatique ou araliphatique bivalent, substitué ou non, ou un radical aromatique bivalent qui porte un alkyle, un alcoxyalkyle, un alcoxy, un triméthylène ou un tétraméthylène.

**4.** Procédé selon la revendication 1 ou matière selon la revendication 3, caractérisés en ce que Z représente un radical répondant à l'une des formules V, VI et VII :

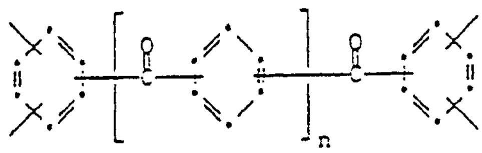 (V),

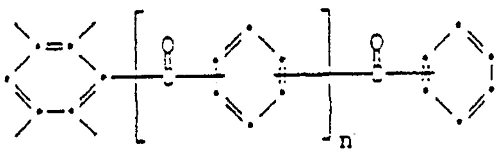 (VI),

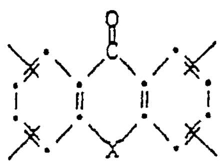 (VII)

dans lesquelles n est égal à 0 ou à 1 et X représente une liaison directe, $-CH_2-$, -O-, -S-, -SO-, $-SO_2-$, $-NR^x-$, $-CR^xR^y-$ ou -CO-, les liaisons libres sont en position ortho, $R^x$ représente H, un alkyle en $C_1$-$C_6$, un phényle, un benzyle ou un cyclohexyle, et $R^y$ a la signification de $R^x$ mais ne peut pas représenter H.

**5.** Procédé selon la revendication 1 ou matière selon la revendication 3, caractérisés en ce que Z répond à l'une des formules suivantes :

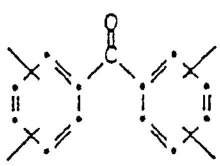 , 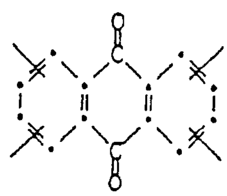 et 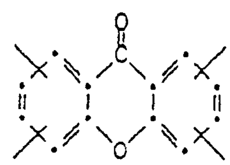

**6.** Procédé selon la revendication 1 ou matière selon la revendication 3, caractérisés en ce que le radical de formule II répond à la formule suivante :

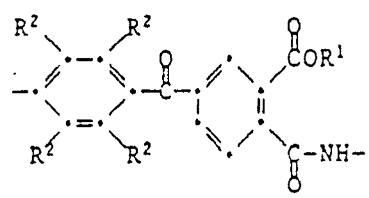

dans laquelle $R^2$ représente un atome d'hydrogène ou un radical méthyle.

**7.** Procédé selon la revendication 1 ou matière selon la revendication 3, caractérisés en ce que le symbole Z' contenu dans la formule III est le radical suivant :

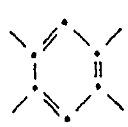

8. Procédé selon la revendication 1 ou matière selon la revendioation 3, caractérisés en ce que le radical de formule IV répond à l'une des formules suivantes :

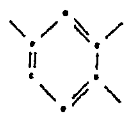 , 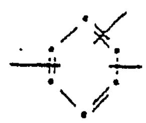 et 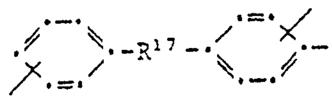

où $R^{17}$ représente une liaison directe ou un radical formant pont, et les liaisons libres sont en position ortho.

9. Procédé selon la revendication 1 ou matière selon la revendication 3, caractérisés en ce que $R^2$ représente un alkyle en $C_1$-$C_4$ et m est égal à 1, à 2, à 3 ou à 4.

10. Procédé selon la revendication 1 ou matière selon la revendication 3, caractérisés en ce que $R^1$ représente un alkyle linéaire ou ramifié, un cycloalkyle ou un aralkyle, substitués ou non.

11. Procédé ou matière selon la revendication 10, caractérisés en ce que $R^1$ représente un alkyle en $C_1$ - $C_{12}$, un cycloalkyle contenant 5 ou 6 atomes de carbone dans son cycle, ou un aralkyle contenant 1 ou 2 atomes de carbone dans sa partie alkylène.

12. Procédé ou matière selon la revendication 11, caractérisés en ce que $R^1$ représente un alkyle en $C_1$ - $C_4$ ou un benzyle.

13. Procédé selon la revendication 1 caractérisé en ce que R représente un radical aliphatique, cycloaliphatique, araliphatique ou aromatique bivalent, substitué ou non.

14. Procédé selon la revendication 1 caractérisé en ce que R contient de 2 à 30 atomes de carbone lorsqu'il est un radical aliphatique, de 5 à 8 atomes de carbone dans son cycle lorsqu'il est un radical cycloaliphatique, de 7 à 30 atomes de carbone lorsqu'il est un radical araliphatique et de 6 à 30 atomes de carbone lorsqu'il est un radical aromatique.

15. Procédé selon la revendication 1 caractérisé en ce que R, en tant que radical aliphatique, est un radical alkylène linéaire ou ramifié qui peut être interrompu par des atomes d'oxygène ou, des radicaux $NR^a$ ou $^+NR^a{}_2G^\bullet$ (dans lesquels $R^a$ représente un alkyle en $C_1$-$C_{12}$, un cycloalkyle à 5 ou 6 atomes de carbone dans son cycle, un phényle ou un benzyle, et $G^\bullet$ représente l'anion d'un acide protonique), un cyclohexylène, un naphtylène, un phénylène ou un radical d'hydantoïne ; en tant que radical cycloaliphatique un radical cycloalkylène mono- ou bicyclique contenant de 5 à 7 atomes de carbone intracycliques, dépourvu de substituant ou porteur d'un alkyle ; en tant que radical araliphatique un aralkylène qui ne porte pas de substituant ou dont la partie aryle porte un alkyle, la partie alkylène pouvant être linéaire ou ramifiée ; et, en tant que radical aromatique, un radical d'hydrocarbure ou de pyridine non substitué ou porteur d'un alkyle, d'un alcoxy, d'un alcoxy-alkyle, d'un triméthylène ou d'un tétraméthylène.

16. Procédé selon la revendication 1 ou matière selon la revendication 3, caractérisés en ce que R, en tant que radical aliphatique, est un radical alkylène linéaire ou ramifié qui contient de 2 à 30 atomes de carbone, un radical $-(CH_2)_x-R^3-(CH_2)y-$ (dans lequel $R^3$ représente un radical phénylène, naphtylène, cyclopentylène ou cyclohexylène et x et y représentent chacun, indépendamment l'un de l'autre, le nombre 1, 2 ou 3), un radical $-R^4-(OR^5)_p-O-R^4-$ dans lequel $R^4$ représente un radical éthylène, propylène-1,2, propylène-1,3 ou méthyl-2 propylène-l,3, $R^5$ représente un radical éthylène, propylène-1,2, butylène-1,2, propylène-1,3, butylène-1,3 ou butylène-1,4, et p désigne un nombre de 1 à 100, ou un radical de formule

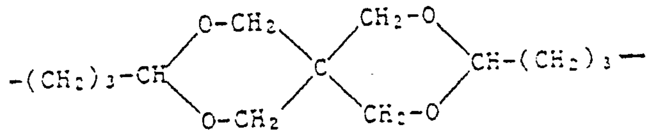

**17.** Procédé selon la revendication 1 ou matière selon la revendication 3, caractérisés en ce que R, en tant que radical cycloaliphatique, représente un tel radical qui répond à l'une des formules :

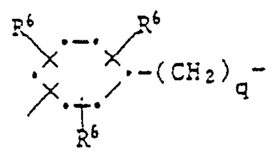

et

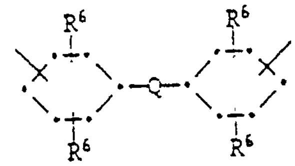

dans lesquelles q est égal à 0 ou à 1, les $R^6$ représentent chacun, indépendamment les uns des autres, l'hydrogène ou un alkyle contenant de 1 à 6 atomes de carbone, et Q représente une liaison directe, 0, S, $SO_2$, un alkylène contenant de 1 à 3 atomes de carbone ou un alkylidène contenant de 2 à 6 atomes de carbone.

**18.** Procédé selon la revendication 1 ou matière selon la revendication 3, caractérisés en ce que R, en tant que radical aromatique, porte un radical alkyle, alcoxy ou alcoxy-alkyle contenant de 1 à 6 atomes de carbone, ou deux atomes de carbone voisins appartenant au radical aromatique portent un radical triméthylène ou tétraméthylène.

**19.** Procédé ou matière selon la revendication 18, caractérisés en ce que, dans la formule I, un ou deux des substituants sont en position ortho par rapport au radical -NH-.

**20.** Procédé selon la revendication 1 ou matière selon la revendication 3, caractérisés en ce que R, en tant que radical aliphatique, répond à la formule suivante:

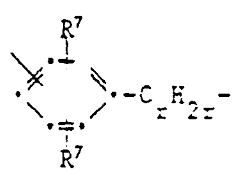

dans laquelle les $R^7$ représentent chacun, indépendament l'un de l'autre, un atome d'hydrogène ou un alkyle contenant de 1 à 6 atomes de carbone, et r désigne un nombre entier de 1 à 16.

**21.** Procédé ou matière selon la revendication 20, caractérisés en ce que la liaison libre se trouve en position para relativement au radical $-C_RH_{2r}-$, et un $R^7$ ou les deux $R^7$, en tant qu'alkyles, sont en position ortho relativement à la liaison libre.

**22.** Procédé selon la revendication 15, caractérisé en ce que les radicaux aromatiques répondent à l'une des formules :

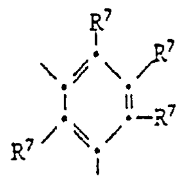 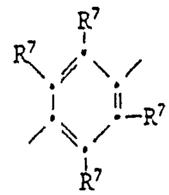 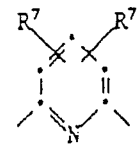

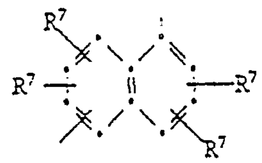 , 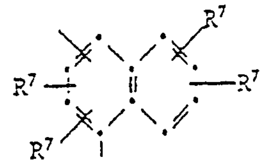 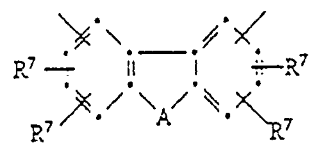

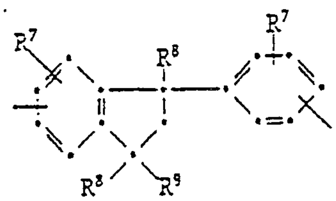 et 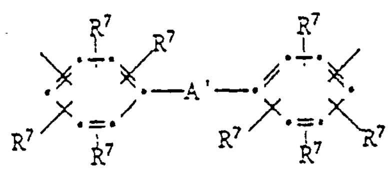

dans lesquelles

les $R^7$ représentent tous un atome d'hydrogène ou, dans le cas de la monosubstitution, un $R^7$ représente un alkyle en $C_1$-$C_6$ et les autres $R^7$ représentent des atomes d'hydrogène, ou, dans le cas de la di-, tri-ou tétra-substitution, deux $R^7$ représentent chacun un alkyle en $C_1$-$C_6$ et les autres $R^7$ représentent chacun un atome d'hydrogène ou un alkyle en $C_1$-$C_6$, ou, dans le cas de la di-, tri- ou tétra-substitution, deux $R^7$ vicinaux sur le noyau phényle représentent un radical triméthylène ou tétraméthylène et les autres $R^7$ représentent chacun un atome d'hydrogène ou un alkyle en $C_1$-$C_6$,

A représente O, S, NH, CO ou $CH_2$,

$R^8$ représente un atome d'hydrogène ou un alkyle contenant de 1 à 5 atomes de carbone,

$R^9$ représente un alkyle contenant de 1 à 5 atomes de carbone, et 0

A' représente une liaison directe, O, S, $SO_2$, CO, CO, O CNR$^{10}$, NR$^{10}$, CONH, NH, $R^{10}SiR^{11}$, $R^{10}OSiOR^{11}$, un alkylène en $C_1$-$C_6$, un alkylidène en $C_2$-$C_6$, un phénylène ou un phénylène-dioxy, les symboles $R^{10}$ et $R^{11}$ représentant chacun, indépendamment l'un de l'autre, un alkyle en $C_1$-$C_6$ ou un phényle.

**23.** Procédé selon la revendication 22 ou matière selon la revendication 3, caractérisés en ce que R représente un radical aromatique répondant à l'une des formules :

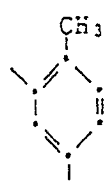 , 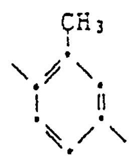 , 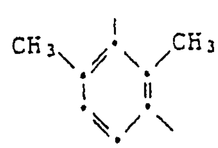 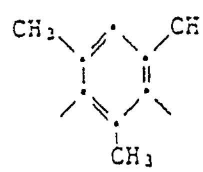

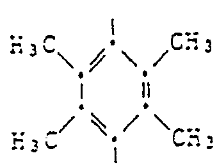 , 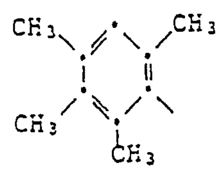 et 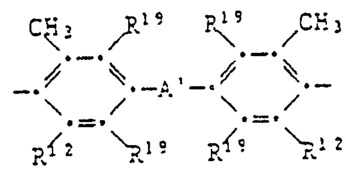

où A' représente une liaison directe, O ou, mieux, $CH_2$, $R^{12}$ représente un atome d'hydrogène ou, plus particulièrement, un radical méthyle ou éthyle, et $R^{19}$ représente un atome d'hydrogène ou, plus particulièrement, un radical méthyle ou éthyle.

**24.** Procédé selon la revendication 1 ou matière selon la revendication 3, caractérisés en ce qu'une proportion pouvant aller jusqu'à 50 % en moles de la composante (a) ou (b) est remplacée par le polyamide-acide correspondant.

**25.** Application du polyamide-acide-ester selon la revendication 1 à la production de couches protectrices ou à la réalisation d'images photographiques par irradiation, éventuellement à travers un photomasque, puis élimination des parties du polycondensat qui n'ont pas été touchées par le rayonnement, et traitement thermique de la couche ou de l'image pour transformer le polyamide-acide-ester en un polyimide.